(19) Europäisches Patentamt
European Patent Office
Office européen des brevets

(11) EP 4 692 947 A1

(12) **EUROPEAN PATENT APPLICATION**
published in accordance with Art. 153(4) EPC

(43) Date of publication:
**11.02.2026 Bulletin 2026/07**

(21) Application number: **24779215.3**

(22) Date of filing: **06.03.2024**

(51) International Patent Classification (IPC):
***G03F 7/32*** *(2006.01)* ***G03F 7/004*** *(2006.01)*
***G03F 7/022*** *(2006.01)* ***G03F 7/027*** *(2006.01)*

(52) Cooperative Patent Classification (CPC):
**G03F 7/004; G03F 7/022; G03F 7/027; G03F 7/32**

(86) International application number:
**PCT/JP2024/008537**

(87) International publication number:
**WO 2024/203080 (03.10.2024 Gazette 2024/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **31.03.2023 JP 2023057642**

(71) Applicant: **FUJIFILM Corporation**
**Tokyo 106-8620 (JP)**

(72) Inventor: **MASUDA, Seiya**
**Haibara-gun, Shizuoka 421-0396 (JP)**

(74) Representative: **HGF**
**HGF Limited**
**4th Floor, 1 City Square**
**Leeds LS1 2AL (GB)**

# (54) CHEMICAL SOLUTION AND PATTERNING METHOD

(57) A first object of the present invention is to provide a chemical liquid that is excellent in removability of a defect on a patterned substrate including a substrate and a pattern containing magnetic particles. Further, a second object of the present invention is to provide a pattern forming method using the chemical liquid.

The chemical liquid of the present invention is a chemical liquid used in forming a pattern and contains magnetic particles, the chemical liquid comprising water, a surfactant, and a water-soluble organic solvent, in which the surfactant includes a water-soluble polymer.

EP 4 692 947 A1

## Description

## BACKGROUND OF THE INVENTION

1. Field of the Invention

The present invention relates to a chemical liquid and a pattern forming method.

2. Description of the Related Art

With performance enhancement and miniaturization of electronic devices, a degree of integration of electronic circuits is increasing. As one of the materials for improving the degree of integration, a material such as a pattern-formable magnetic particle-containing composition has been studied. By using such a material, it is possible to mount a magnetic material having an optional shape, and thus it is easy to realize miniaturization and high performance of an electronic device as compared with a method of disposing individual pieces of a magnetic material in the related art on a chip.

For example, WO2022-065006A discloses a photosensitive composition containing pattern-formable magnetic particles. WO2022-065006A discloses a procedure for manufacturing a patterned substrate having a substrate and a pattern containing magnetic particles disposed on the substrate by subjecting a coating film of a photosensitive composition including magnetic particles formed on the substrate to an exposure treatment, an alkaline development treatment, and a rinsing treatment using water.

## SUMMARY OF THE INVENTION

The present inventors have studied a pattern forming method using a photosensitive composition including magnetic particles with reference to WO2022-065006A, and have found that, typically, since the magnetic particles have a large specific gravity and are heavier than water, the magnetic particles that should originally be removed remain on the surface of the substrate with a pattern even after a rinsing treatment, which easily causes defects.

In particular, in recent years, as the pattern is miniaturized, a more severe defect removability is required than before, and further improvement is required in order to reduce the number of defects on the substrate with a pattern.

Therefore, an object of the present invention is to provide a chemical liquid having excellent removability of defects on a substrate with a pattern, which includes a substrate and a pattern containing magnetic particles.

In addition, another object of the present invention is to provide a pattern forming method using the above-described chemical liquid.

As a result of intensive studies to achieve the above-described objects, the present inventors have found that the above-described objects can be achieved by the following configurations, and have completed the present invention.

[1] A chemical liquid used in forming a pattern containing magnetic particles, the chemical liquid including:

water;
a surfactant; and
a water-soluble organic solvent,
in which the surfactant includes a water-soluble polymer.

[2] The chemical liquid according to [1], in which in a case of forming the pattern containing the magnetic particles, the chemical liquid is used as a rinse liquid that is used after an alkaline development treatment.
[3] The chemical liquid according to [1] or [2], further including a polyhydric alcohol.
[4] The chemical liquid according to any one of [1] to [3], further including a pH adjuster selected from the group consisting of an organic amine, a salt thereof, an organic acid, and a salt thereof.
[5] The chemical liquid according to any one of [1] to [4], in which the water-soluble organic solvent is an alcohol.
[6] The chemical liquid according to any one of [1] to [5], in which a content of the water is 60.0% by mass or more with respect to a total mass of a composition.
[7] A pattern forming method including:

a step of applying any one of a composition A containing magnetic particles, a resin, a polymerizable compound, and a solvent, or a composition B containing magnetic particles, a resin, a compound that is alkali-solubilized by light irradiation, a crosslinking agent, and a solvent onto a substrate to form a coating film;
a step of subjecting the coating film to pattern exposure;
a step of alkali-developing the coating film subjected to the pattern exposure; and

a step of rinsing a substrate having the alkali-developed coating film with the chemical liquid according to claim 1 to form a pattern containing the magnetic particles,
wherein in a case where the composition is the composition B, a step of performing heating treatment on the substrate having the coating film rinsed with the chemical liquid is further provided.

[8] A pattern forming method including:

a step of applying a composition A containing magnetic particles, a resin, a polymerizable compound, and a solvent onto a substrate by an inkjet method or a screen method to form a patterned coating film;
a step of performing a curing treatment on the coating film; and
a step of washing a substrate having the cured coating film with the chemical liquid according to [1] to [6] to form a pattern containing the magnetic particles.

[9] The pattern forming method as described in [7] or [8], in which the substrate is a silicon wafer.
[10] The pattern forming method as described in any one of [7] to [9], in which a thickness of the coating film is 300 μm or less.

According to the present invention, it is possible to provide a chemical liquid having excellent removability of defects on a patterned board including a substrate and a pattern containing magnetic particles.
In addition, according to the present invention, it is possible to provide a pattern forming method using the above-described chemical liquid.

## DESCRIPTION OF THE PREFERRED EMBODIMENTS

Hereinafter, the present invention will be described in detail.
Description of configuration requirements described below may be made on the basis of representative embodiments of the present invention in some cases, but the present invention is not limited to such embodiments.
In notations for a group (atomic group) in the present specification, in a case where the group is cited without specifying that it is substituted or unsubstituted, the group includes both a group having no substituent and a group having a substituent as long as it does not impair the spirit of the present invention. For example, an "alkyl group" includes not only an alkyl group having no substituent (unsubstituted alkyl group), but also an alkyl group having a substituent (substituted alkyl group). In addition, "organic group" in the present specification refers to a group including at least 1 carbon atom.
"Actinic rays" or "radiation" in the present specification means, for example, a bright line spectrum of a mercury lamp, far ultraviolet rays typified by an excimer laser, extreme ultraviolet (EUV light), X-rays, electron beams (EB), or the like. "Light" in the present specification means actinic ray or radiation.
Unless otherwise specified, "exposure" in the present specification encompasses not only exposure by a bright line spectrum of a mercury lamp, far ultraviolet rays typified by an excimer laser, extreme ultraviolet rays, X-rays, EUV light, or the like, but also drawing by particle beams such as electron beams and ion beams.
In the present specification, a numerical range expressed using "to" is used in a meaning of a range that includes the preceding and succeeding numerical values of "to" as the lower limit value and the upper limit value, respectively.
In the present specification, (meth)acrylate represents acrylate or methacrylate, (meth)acryl represents acryl or methacryl, and (meth)acryloyl represents acryloyl or methacryloyl.
In the present specification, "solid content" of a composition means components forming a magnetic material. Therefore, in a case where the composition contains a solvent (such as an organic solvent and water), the "solid content" means all the components excluding the solvent. In a case where the components are components which form the magnetic material, the components are considered to be solid content even in a case where the components are liquid components.
In the present specification, "boiling point" means a standard boiling point, unless otherwise specified.
In addition, in the present specification, a weight-average molecular weight (Mw) is a value by a gel permeation chromatography (GPC) method in terms of polystyrene.
In addition, in the present specification, for each component, unless otherwise specified, one kind of substance corresponding to each component may be used alone, or two or more kinds thereof may be used in combination. Here, in a case where two or more kinds of substances corresponding to respective components are used in combination, the content of the components indicates the total content of the substances used in combination unless otherwise specified.

[Chemical liquid]

The chemical liquid of the present invention is a chemical liquid used in forming a pattern containing magnetic

particles, the chemical liquid includes:

water;
a surfactant; and
a water-soluble organic solvent,
wherein the surfactant includes a water-soluble polymer.

The chemical liquid according to the embodiment of the present invention is excellent in removability of defects on a patterned board including a substrate and a pattern containing magnetic particles, due to the above-described configuration. The mechanism of action is not specifically clear, but the present inventors have presumed as follows.
In the manufacturing of the patterned board including a substrate and a pattern containing magnetic particles, the magnetic particles remaining on the patterned board are often released from components that improve the dispersibility of particles such as a dispersant. Therefore, even in a case where the patterned board is subjected to a washing treatment with water, the magnetic particles are inferior in dispersibility in water, and thus the magnetic particles are hardly removed from the board. On the other hand, in a case where the chemical liquid according to the embodiment of the present invention is used in the manufacturing of the patterned board, the residues of the magnetic particles on the patterned board are likely to be wrapped in the water-soluble polymer and redispersed in the solvent, and as a result, the number of defects derived from the magnetic particles remaining on the patterned board can be reduced. That is, the chemical liquid according to the embodiment of the present invention is excellent in the removability of defects on a patterned substrate including a substrate and a pattern containing magnetic particles.
In a case where the chemical liquid according to the embodiment of the present invention is applied to a pattern forming method for manufacturing a substrate with a pattern by, for example, a pattern forming method including an exposure treatment, a development treatment, and a rinsing treatment, the chemical liquid is also excellent in removability of residues of magnetic particles attached to a side wall and a drain of a development cup. That is, it is also possible to wash the magnetic particle residues attached to the side wall and the drain of the development cup, and thus it is also possible to suppress the accumulation of the magnetic particles and the piping in the bottom portion of the development cup.
Hereinafter, in a case of forming a pattern containing magnetic particles using the chemical liquid according to the embodiment of the present invention, the fact that the removability of the defect on the pattern-attached substrate including the substrate and the pattern containing the magnetic particles is more excellent is also referred to as "the effect of the present invention is more excellent".
Hereinafter, first, components constituting the chemical liquid according to the embodiment of the present invention will be described in detail.

[Water]

The chemical liquid contains water.
The water is preferably water that has been subjected to a purification treatment, such as distilled water, ion exchange water, and ultrapure water, and more preferably ultrapure water used for manufacturing semiconductors.
The lower limit value of the content of water in the chemical liquid is preferably 60.0% by mass or more, more preferably 65.0% by mass or more, and still more preferably 70.0% by mass or more. An upper limit value thereof is preferably 95.0% by mass or less, more preferably 90.0% by mass or less, still more preferably 85.0% by mass or less, and particularly preferably 80.0% by mass or less.

[Surfactant]

The chemical liquid contains a surfactant.
The surfactant is a compound having a hydrophilic group and a hydrophobic group (a lipophilic group) in molecule.
The surfactant contained in the chemical liquid may be, for example, any of a nonionic surfactant, an anionic surfactant, a cationic surfactant, or an amphoteric surfactant.
The lower limit value of the content of the surfactant in the chemical liquid is preferably 0.01% by mass or more, more preferably 0.05% by mass or more, and still more preferably 0.10% by mass or more. In addition, an upper limit value thereof is preferably 3.0% by mass or less, more preferably 1.5% by mass or less, still more preferably 1.0% by mass or less, and particularly preferably 0.5% by mass or less.
The surfactants may be used alone or in combination of two or more kinds thereof. In a case where two or more kinds of the compounds are used, a total content thereof is preferably within the suitable content range.
The chemical liquid contains a water-soluble polymer as a surfactant.
Here, the term "water-soluble" means that the solubility in water (20°C) is 0.5 g/1 L or more.

The water-soluble polymer is preferably a nonionic surfactant.

Among these, a compound having a polyoxyalkylene structure is more preferable as the water-soluble polymer.

The polyoxyalkylene structure is a structure represented by -(A-O)n- (A represents an alkylene group, n represents an average addition number, for example, a number of 2 to 100). Examples of the oxyalkylene group represented by A-O include an ethylene oxide group and a propylene oxide group. In addition, the polyoxyalkylene structure may include a plurality of kinds of oxyalkylene groups. The polyoxyalkylene structure may be included in the main chain or may be included in the side chain.

Specific examples of the compound having a polyoxyalkylene structure include a polypropylene glycol ethylene oxide adduct; a dimethylsiloxane-ethylene oxide block copolymer; a dimethylsiloxane-(propylene oxide-ethylene oxide) block copolymer; a polyethylene glycol type higher alcohol ethylene oxide adduct; a fatty acid ethylene oxide adduct; a higher alkylamine ethylene oxide adduct; and a fatty acid amide ethylene oxide adduct.

In addition, as the water-soluble polymer other than the compound having a polyoxyalkylene structure, for example, lysozyme, which is a sugar-decomposing enzyme, can also be used.

The lower limit value of the weight-average molecular weight (Mw) of the water-soluble polymer is preferably 50 or more. In addition, the upper limit value thereof is preferably 100,000 or less, more preferably 30,000 or less, and still more preferably 10,000 or less.

The lower limit value of the number-average molecular weight (Mn) of the water-soluble polymer is preferably 10 or more. In addition, the upper limit value thereof is preferably 1,000 or less, more preferably 500 or less, and still more preferably 200 or less.

Examples of the water-soluble polymer product include "POLOXAMER 407" (manufactured by Sigma-Aldrich Co. LLC, a polymer having a poly(ethylene glycol)-block-poly(propylene glycol)-block-poly(ethylene glycol) structure); "MALIALIM SC0505K", "DISPANOL WI-133", and "ESLIM AD3172M" (all manufactured by NOF CORPORATION, polymers having a polyoxyalkylene group in a side chain); and "OLFIN E1010" (manufactured by Nissin Chemical Co., Ltd., polyoxyethylene (10) acetylenic glycol ether).

The lower limit value of the content of the water-soluble polymer in the chemical liquid is preferably 0.01% by mass or more, more preferably 0.05% by mass or more, and still more preferably 0.10% by mass or more. In addition, an upper limit value thereof is preferably 3.0% by mass or less, more preferably 1.5% by mass or less, still more preferably 1.0% by mass or less, and particularly preferably 0.5% by mass or less.

The water-soluble polymer may be used alone or in combination of two or more kinds thereof. In a case where two or more kinds of the compounds are used, a total content thereof is preferably within the suitable content range.

As the surfactant other than the water-soluble polymer, a compound known as an anionic surfactant, a cationic surfactant, a nonionic surfactant, or an amphoteric surfactant can be used, but among these, a nonionic surfactant is preferable.

Specific examples of the surfactant other than the water-soluble polymer include an alkylphenol ethylene oxide adduct; an aromatic compound polyethylene glycol adduct; a polyhydric alcohol fatty acid ester ethylene oxide adduct; an ethylene oxide adduct of an oil and fat; a polyhydric alcohol type glycerol fatty acid ester; a fatty acid ester of pentaerythritol; a fatty acid ester of sorbitol and sorbitan; a fatty acid ester of sucrose; an alkyl ether of a polyhydric alcohol; and a fatty acid amide of an alkanolamine.

Examples of a commercially available product of the surfactant other than the water-soluble polymer include "SURFYNOL 104E" and "SURFYNOL 440" (manufactured by Nissin Chemical Co., Ltd., polyether of acetylene dialcohol).

[Water-soluble organic solvent]

The chemical liquid contains a water-soluble organic solvent.

Here, the term "water-soluble" means that the solubility in water (20°C) is 0.5 g/1 L or more.

Specific examples of the water-soluble organic solvent include methanol, ethanol, isopropanol, n-propanol, isobutanol, n-butanol, diethylene glycol monomethyl ether, diethylene glycol monoethyl ether, diethylene glycol monobutyl ether, methyl cellosolve, ethyl cellosolve, butyl cellosolve, 2-methoxypropanol, ethylene glycol monopropyl ether, diethylene glycol monobutyl ether, triethylene glycol monobutyl ether, propylene glycol monomethyl ether (PGME), dipropylene glycol monomethyl ether, and propylene glycol monomethyl ether acetate (PGMEA).

Among these, as the water-soluble organic solvent, a monohydric alcohol (an alcohol having only one hydroxy group) is preferable, an aliphatic alcohol is more preferable, an aliphatic alcohol having 5 or less carbon atoms is still more preferable, ethanol or methanol is particularly preferable, and ethanol is most preferable.

The lower limit value of the content of the water-soluble organic solvent in the chemical liquid is preferably 10.0% by mass or more, more preferably 15.0% by mass or more, and still more preferably 18.0% by mass or more. The upper limit value thereof is preferably 40.0% by mass or less, more preferably 35.0% by mass or less, and still more preferably 30.0% by mass or less.

The water-soluble organic solvent may be used alone or in combination of two or more kinds thereof. In a case

where two or more kinds of the compounds are used, a total content thereof is preferably within the suitable content range.

[Polyhydric alcohol]

It is preferable that the chemical liquid contains a polyhydric alcohol.
The polyhydric alcohol is not particularly limited as long as it is a di- or higher valent alcohol, and is preferably an alkylene glycol, a polyoxyalkylene glycol, or glycerin.
The number of carbon atoms in the alkyl group moiety in the alkylene glycol is preferably 1 to 4 and more preferably 2 or 3. In addition, the alkyl group moiety is preferably linear or branched.
In the polyoxyalkylene glycol, the number of carbon atoms in the oxyalkylene group is preferably 1 to 4 and more preferably 2 or 3. In addition, in addition, the oxyalkylene group is preferably linear or branched. In the polyoxyalkylene glycol, the repetition number of the oxyalkylene group is preferably 2 to 4.
Specific examples of the polyhydric alcohol include ethylene glycol, diethylene glycol, propylene glycol, and glycerin.
The lower limit value of the content of the polyhydric alcohol in the chemical liquid is preferably 0.1% by mass or more, more preferably 0.5% by mass or more, and still more preferably 1.0% by mass or more. The upper limit value thereof is preferably 15.0% by mass or less, more preferably 10.0% by mass or less, and still more preferably 8.0% by mass or less.
The polyhydric alcohol may be used alone or in combination of two or more kinds thereof. In a case where two or more kinds of the compounds are used, a total content thereof is preferably within the suitable content range.

[pH adjuster]

It is preferable that the chemical liquid contains a pH adjuster selected from the group consisting of an organic amine and a salt thereof, and an organic acid and a salt thereof.

<Organic amine and salt thereof>

The organic amine and a salt thereof are a compound having, in a molecule, at least one amino group selected from the group consisting of a primary amino group ($-NH_2$), a secondary amino group (>NH), a tertiary amino group (>N-), and a quaternary ammonium group ($>N^+<$), or a salt thereof.
The organic amine may be a low-molecular-weight compound or a polymer compound, but a low-molecular-weight compound is preferable from the viewpoint that the effect of the present invention is more excellent.
The number of amino groups contained in the organic amine is, for example, preferably 1 to 10, more preferably 1 to 5, and still more preferably 1 to 3.
The organic amine may be linear, branched, or cyclic.
Examples of the organic amine and a salt thereof include an alkanolamine, an alicyclic amine, an aliphatic amine, an aromatic amine, and a quaternary ammonium salt.
Among the organic amines, the alkanolamine is a compound further having at least one hydroxyalkyl group in the molecule. The alkanolamine may have any of a primary amino group, a secondary amino group, or a tertiary amino group, but preferably has a primary amino group.
The number of amino groups included in the alkanolamine is, for example, 1 to 5, preferably 1 to 3. The number of hydroxy groups included in the alkanolamine is, for example, 1 to 5, and more preferably 1 to 3.
Among these, it is more preferable that the alkanolamine has only a primary amino group as the amino group.
Specific examples of the alkanolamine include monoethanolamine, diethanolamine, triethanolamine, monoisopropanolamine, and isopropanolamine.
Examples of the alicyclic amine include morpholine and N-hydroxyethylmorpholine.
Examples of the aliphatic amine include monomethylamine, dimethylamine, trimethylamine, monoethylamine, diethylamine, triethylamine, monoisopropylamine, diisopropylamine, triisopropylamine, n-butylamine, ethylenediamine, trimethylenediamine, and polyethyleneimine.
Examples of a commercially available product of polyethyleneimine include "EPOMIN P1000" (manufactured by Nippon Kayaku Co., Ltd.).
Examples of the aromatic amine include pyridine, aniline, N,N-dimethylaniline, N,N-diethylaniline, and N,N-diethanol aniline.
Examples of the quaternary ammonium salt include a quaternary ammonium hydroxide, a quaternary ammonium fluoride, a quaternary ammonium bromide, a quaternary ammonium iodide, a quaternary ammonium acetate, and a quaternary ammonium carbonate, and among these, a quaternary ammonium hydroxide is preferable.
As the quaternary ammonium salt, a tetraalkylammonium salt is preferable. The number of carbon atoms in each of the four alkyl groups is preferably 1 to 6 and more preferably 1 to 3.

Specific examples of the quaternary ammonium salt include tetramethylammonium hydroxide.

<Organic acid and salt thereof>

The organic acid refers to an organic compound that exhibits acidity in a case where the compound is dissolved in water to form an aqueous solution thereof. An acid dissociation constant (pKa) of the organic acid is preferably 10.0 or less, and more preferably 5.0 or less. The lower limit of the acid dissociation constant of the organic acid is -2.0 or more, and preferably 0.0 or more.

In the present specification, a compound having an amino group among the organic acids is referred to as an organic acid.

Examples of the organic acid include an organic compound having one or more acid groups in the molecule, and examples of the acid group include a carboxylic acid group, a phosphonic acid group, a phosphoric acid group, a sulfonic acid group, and a sulfamic acid group.

In addition, the acid group of the organic acid may have a salt structure. The salt of the organic acid is not particularly limited, and examples thereof include an alkali metal salt such as a potassium salt and a sodium salt; an alkaline earth metal salt such as a calcium salt and a magnesium salt; an amine salt; and an ammonium salt. The salt of the organic acid may have a betaine structure (intramolecular salt).

Examples of the organic acid and the salt thereof include an organic carboxylic acid and a salt thereof, an organic sulfonic acid and a salt thereof, an organic phosphonic acid and a salt thereof, an organic phosphoric acid and a salt thereof, sulfamic acid and a salt thereof, and the like. Among these, an organic carboxylic acid and a salt thereof are preferable from the viewpoint that the effect of the present invention is more excellent.

As the organic acid, an organic acid having a hydroxy group in the molecule is also preferable. In a case where the organic acid has a hydroxy group in the molecule, the number of hydroxy groups is, for example, 1 to 6.

The organic acid is preferably an aliphatic organic acid.

(Organic carboxylic acid and salt thereof)

As the organic carboxylic acid, an aliphatic carboxylic acid is preferable.

The number of carboxy groups contained in the organic carboxylic acid may be 1 or more. That is, the organic acid may be an aliphatic monocarboxylic acid or an aliphatic polycarboxylic acid. In the aliphatic polycarboxylic acid, the upper limit of the number of carboxy groups is, for example, 5 or less, and is more preferably 4 or less, and still more preferably 3 or less.

In addition, the organic carboxylic acid may have a substituent (for example, a hydroxy group) other than the carboxy group.

As the aliphatic monocarboxylic acid, a compound represented by Formula (X1) is preferable.

$$R^{X1}\text{-COOH} \qquad (X1)$$

In Formula (X1), $R^{X1}$ represents an alkyl group having 1 to 6 carbon atoms. The alkyl group represented by $R^{X1}$ may be linear, branched, or cyclic. The methylene group constituting the alkyl group represented by $R^{X1}$ may be substituted with -O-.

Examples of the alkyl group represented by $R^{X1}$ include a methyl group, an ethyl group, a propyl group, an isopropyl group, a butyl group, and a cyclohexyl group.

Examples of the compound represented by Formula (X1) include acetic acid.

As the aliphatic polycarboxylic acid, a compound represented by Formula (X2) is preferable.

$$\text{HOOC-}R^{x2}\text{-COOH} \qquad (X2)$$

In Formula (X2), $R^{X2}$ represents a single bond or an alkylene group having 1 to 6 carbon atoms. The alkylene group represented by $R^{X2}$ may be linear, branched, or cyclic. The methylene group constituting the alkylene group represented by $R^{X2}$ may be substituted with -O-. The hydrogen atom in the alkyl group represented by $R^{X2}$ may be substituted with a carboxy group.

Examples of the alkylene group represented by $R^{X2}$ include a methylene group, an ethylene group, a propylene group, a butylene group, and a cyclohexylene group.

Examples of the compound represented by Formula (X2) include oxalic acid, malonic acid, succinic acid, glutaric acid, adipic acid, and cyclohexanedicarboxylic acid.

As the aliphatic hydroxy monocarboxylic acid, a compound represented by Formula (X3) is preferable.

$R^{X3}$-COOH (X3)

In Formula (X3), $R^{X3}$ represents an alkyl group having 1 to 6 carbon atoms, which has a hydroxy group. The alkyl group having a hydroxy group, represented by $R^{X3}$, may be linear, branched, or cyclic. The methylene group constituting the alkyl group having a hydroxy group, which is represented by $R^{X3}$, may be substituted with -O-. Examples of the alkyl group having a hydroxy group, which is represented by $R^{X3}$, include a group in which one or more hydrogen atoms of the alkyl group represented by $R^{X1}$ are substituted with a hydroxy group.
Examples of the compound represented by Formula (X3) include glycolic acid, lactic acid, glyceric acid, hydroxybutyric acid, gluconic acid, and glucuronic acid.
As the aliphatic hydroxypolycarboxylic acid, a compound represented by Formula (X4) is preferable.

HOOC-$R^{X4}$-COOH (X4)

In Formula (X4), $R^{X4}$ represents an alkylene group having 1 to 6 carbon atoms, which has a hydroxy group. The alkylene group having a hydroxy group, represented by $R^{X4}$, may be linear, branched, or cyclic. The methylene group constituting the alkylene group having a hydroxy group, which is represented by $R^{X4}$, may be substituted with -O-. The hydrogen atom in the alkyl group having a hydroxy group, which is represented by $R^{X4}$, may be substituted with a carboxy group.
Examples of the alkylene group having a hydroxy group, represented by $R^{X4}$, include a group in which one or more hydrogen atoms of the alkylene group represented by $R^{X2}$ are substituted with a hydroxy group.
Examples of the compound represented by Formula (X4) include tartaric acid, malic acid, tartaric acid, and citric acid.
In addition, examples of the organic carboxylic acid other than the compound represented by Formulae (X1) to (X4) include higher fatty acids having 12 or more carbon atoms.
Examples of the higher fatty acid having 12 or more carbon atoms include a higher fatty acid having 12 to 18 carbon atoms, and among these, lauric acid is preferable.
In addition, the organic carboxylic acid other than the above-described organic carboxylic acid may be an amino acid. The amino acid refers to an organic compound having an amino group and a carboxy group in the molecule.
Examples of the amino acid include an α-amino acid having an amino group at a carbon atom (α-carbon) to which a carboxy group is bonded, a β-amino acid having an amino group at a carbon atom (β-carbon) which is bonded to α-carbon, and a γ-amino acid having an amino group at a carbon atom (γ-carbon) which is bonded to α-carbon.
Examples of the amino acid include arginine, asparagine, glutamine, histidine, lysine, hydroxylysine, and tryptophan.
As the organic carboxylic acid, one or more selected from the group consisting of acetic acid, tartaric acid, oxalic acid, citric acid, malic acid, lactic acid, and gluconic acid are preferable, and citric acid is more preferable.

(Organic sulfonic acid and salt thereof)

Examples of the organic sulfonic acid include aliphatic sulfonic acids such as alkyl sulfonic acid and α-olefin sulfonic acid; aromatic sulfonic acids; and alkyl ether sulfuric acid.
Examples of the alkyl sulfonic acid include an alkyl sulfonic acid having 12 to 20 carbon atoms. Examples of the alkyl sulfonic acid include octadecyl sulfate.
Examples of the α-olefin sulfonic acid include an α-olefin sulfonic acid having 14 to 16 carbon atoms.
Examples of the aromatic sulfonic acid include a substituted or unsubstituted benzenesulfonic acid. Examples of the substituent include a halogen atom, an alkyl group, an alkoxy group, an alkylcarbonyloxy group, a thiol group, and a hydroxy group. Specific examples of the aromatic sulfonic acid include toluene sulfonic acid and benzenesulfonic acid.
Examples of the alkyl ether sulfate include polyoxyethylene alkyl ether sulfate.
The organic sulfonic acid is preferably a salt structure and more preferably an alkali metal salt.

(Organic sulfamic acid and salt thereof)

Examples of the organic sulfamic acid include an alkylsulfamino acid, and examples thereof include an alkylsulfamino acid having 12 to 20 carbon atoms.
The organic sulfamic acid is preferably a salt structure and more preferably an alkali metal salt.

(Organic phosphonic acid and salt thereof)

Examples of the organic phosphonic acid include an aromatic phosphonic acid. Examples of the aromatic

phosphonic acid include a substituted or unsubstituted phenylphosphonic acid. Examples of the substituent include a halogen atom, an alkyl group, an alkoxy group, an alkylcarbonyloxy group, a thiol group, and a hydroxy group. Specific examples of the aromatic phosphonic acid include phenylphosphonic acid.

(Organic phosphoric acid and salt thereof)

Examples of the organic phosphoric acid include an alkyl phosphoric acid, and examples thereof include an alkyl phosphoric acid having 12 to 20 carbon atoms.

The lower limit value of the content of the pH adjuster in the chemical liquid is preferably 0.001% by mass or more, more preferably 0.01% by mass or more, and still more preferably 0.05% by mass or more. In addition, the upper limit value thereof is preferably 2.0% by mass or less, more preferably 1.5% by mass or less, and still more preferably 1.0% by mass or less.

The pH adjuster may be used alone or in combination of two or more kinds thereof. In a case where two or more kinds of the compounds are used, a total content thereof is preferably within the suitable content range.

[Other components]

Examples of other components which may be contained in the chemical liquid include an anticorrosive agent, a bactericide, an antibacterial agent, a disinfectant, and an antifoaming agent. In addition, a surfactant other than the water-soluble polymer may be contained.

[PH of chemical liquid]

The pH of the chemical liquid may be either acidic or basic.

In a case where the chemical liquid is acidic, the pH is preferably 1 to 6 and more preferably 1 to 4.

In a case where the chemical liquid is basic, the pH is preferably 8 to 14, and more preferably 10 to 14.

In a case where the pH of the chemical liquid is within the above-described range, the surface charge of the magnetic particles taken into the chemical liquid during washing in the pattern formation is increased, and the magnetic particles are more easily dispersed in the chemical liquid. As a result, the effect of the present invention is more excellent.

In the present specification, the pH of the chemical liquid is determined by measuring pH at 25°C by using a pH meter (F-51 (trade name) manufactured by HORIBA, Ltd.).

Examples of the method of adjusting the pH include a method of adjusting the type and content of each component that can be contained in the chemical liquid, and a method of adding the above-described pH adjuster.

<Suitable aspect of chemical liquid>

Examples of a suitable aspect of the chemical liquid include a configuration including water; a surfactant containing a water-soluble polymer; a water-soluble organic solvent; a pH adjuster selected from the group consisting of an organic amine and a salt thereof, and an organic acid and a salt thereof; and a polyhydric alcohol.

In addition, an example of a suitable aspect of the chemical liquid includes a configuration in which the total content of water and the water-soluble organic solvent is 90.0% by mass or more (preferably 95.0% by mass or more) with respect to the total mass of the composition.

<Method for producing chemical liquid>

The method for producing the chemical liquid is not particularly limited, and the chemical liquid can be prepared by mixing the above-described components.

The order and/or timing of mixing the above-described components is not particularly limited, and for example, the water-soluble polymer and the water-soluble organic solvent may be sequentially added to a container containing water, and then stirred and mixed. In addition, after the mixing, a pH adjuster may be added thereto to adjust the pH of the mixed solution. In addition, in a case where the water and the respective components are charged into the container, the water and the respective components may be charged at once, or may be charged in a divided manner a plurality of times.

As a stirring device and a stirring method used for preparing the chemical liquid, a known device may be used as a stirrer or a disperser. Examples of a stirrer include an industrial mixer, a portable stirrer, a mechanical stirrer, and a magnetic stirrer. Examples of the disperser include an industrial disperser, a homogenizer, an ultrasonic disperser, and bead mills.

In the preparation of the chemical liquid, it is preferable to perform a purification treatment in advance on any one or more of raw materials for preparing the chemical liquid. Examples of the purification treatment include known methods

such as distillation, ion exchange, and filtration (filtering).

The mixing of each component, the purification treatment, and the storage of the produced chemical liquid in the chemical liquid preparation step are performed at preferably 40°C or lower and more preferably 30°C or lower. In addition, the lower limit thereof is preferably 5°C or higher, and more preferably 10°C or higher. By performing the preparation, purification treatment, and/or storage of the chemical liquid in the above-described temperature range, the performance can be stably maintained for a long period of time.

[Applications of chemical liquid]

The chemical liquid can be used as a washing solution for removing magnetic particles remaining on the surface of the substrate with a pattern in a case of forming a pattern containing magnetic particles.

A method of forming a pattern containing magnetic particles is not particularly limited, and examples thereof include a lithography method using a photosensitive composition including magnetic particles, and various methods such as an ink jet method and a screen method.

In a case where the method of forming a pattern containing magnetic particles is a lithography method, the chemical liquid is preferably used as a rinsing liquid in a rinsing treatment performed after an exposure treatment and a development treatment, and particularly preferably used as a rinsing liquid in a rinsing treatment performed after an exposure treatment and an alkaline development treatment.

In a case where the method of forming a pattern containing magnetic particles is an ink jet method or a screen method, it is preferable that the washing solution is used in a case of washing after a curing treatment of a patterned coating film including magnetic particles, which is formed on a substrate.

[Pattern forming method]

Hereinafter, the pattern forming method using a chemical liquid will be described in detail.

[Pattern forming method of first aspect]

The pattern forming method of the first aspect includes the steps X1, X2, X3, and X4, and it is preferable that, in a case where the composition is the composition B, the step X4 further includes a step of subjecting a substrate having a coating film rinsed with a chemical liquid to a heating treatment. That is, it is preferable that the pattern forming method of the first aspect includes the steps X1, X2, X3, and X4 in a case where the composition is the composition A, and includes the steps X1, X2, X3, and X5 in a case where the composition is the composition B.

Step X1: step of applying a composition A containing magnetic particles, a resin, a polymerizable compound, and a solvent, or a composition B containing magnetic particles, a resin, a compound that is alkali-solubilized upon irradiation with light, a crosslinking agent, and a solvent onto a substrate to form a coating film

Step X2: step of subjecting the coating film to pattern exposure

Step X3: step of alkali-developing the coated film subjected to the pattern exposure

Step X4: step of rinsing the substrate having the coating film which has been subjected to alkali development with a chemical liquid to form a pattern containing magnetic particles

Step X5: step of rinsing the substrate having the coating film which has been subjected to alkali development with a chemical liquid, and further subjecting the substrate having the coating film which has been rinsed with the chemical liquid to a heating treatment to form a pattern containing magnetic particles

Hereinafter, the steps X1 to X5 will be described.

<Step X1>

The step X1 is a step of applying a composition including each component such as magnetic particles onto a substrate to form a coating film. The composition may be either a negative tone photosensitive composition or a positive tone photosensitive composition. The composition will be described in the latter part.

The substrate is not particularly limited, and examples thereof include a substrate used for manufacturing an integrated circuit element, such as a silicon substrate, a silicon dioxide-coated substrate, and a polyimide base, and among these, a silicon wafer is preferable. In addition, a member such as an antenna may be disposed on the substrate.

As the composition, various coating methods such as a slit coating method, an inkjet method, a rotary coating method using a spinner, a coater, or the like, a casting coating method, a roll coating method, and a screen printing method can be applied onto a substrate. The lower limit value of the thickness of the coating film is, for example, preferably 1 μm or

more, more preferably 10 μm or more, and still more preferably 15 μm or more. In addition, the upper limit value is preferably 10,000 μm or less, more preferably 1,000 μm or less, still more preferably 800 μm or less, and still more preferably 300 μm or less.

The coating film disposed on the substrate may be subjected to a heating treatment (pre-baking). A heating temperature is, for example, preferably 50°C to 140°C and more preferably 80°C to 120°C. The heating time is, for example, preferably 30 to 1,800 seconds, more preferably 60 to 1,000 seconds, and still more preferably 60 to 800 seconds.

<Step X2>

The step X2 is a step of subjecting the coating film obtained in the step X1 to pattern exposure.

The method of the exposure treatment is not particularly limited, but it is preferable that the coating film is irradiated with light through a photo mask having a patterned opening portion.

It is preferable that the exposure is performed by irradiation with radiation. As the radiation that can be used in the exposure, for example, ultraviolet rays such as g-rays, h-rays, and i-rays are preferable, and as a light source, a high-pressure mercury lamp is preferable. The irradiation intensity is preferably 5 to 1,500 $mJ/cm^2$ and more preferably 10 to 1,000 $mJ/cm^2$.

<Step X3>

The step X3 is a step of alkali-developing the coating film subjected to the pattern exposure. In a case where the composition A is used as the composition, a negative pattern can be formed by the step X3. In a case where the composition B is used as the composition, a positive pattern can be formed by the step X3.

Examples of a developing method include a method in which the substrate is immersed in a tank filled with a developer for a certain period of time (a dipping method), a method in which a development is performed by heaping a developer up onto the surface of the substrate by surface tension, and then leaving it to stand for a certain period of time (a puddle method), a method in which a developer is sprayed on the surface of the substrate (a spraying method), and a method in which a developer is continuously jetted onto the substrate rotating at a constant rate while scanning a developer jetting nozzle at a constant rate (a dynamic dispensing method).

In addition, after the step of performing the development, a step of stopping the development may be carried out while replacing the solvent with another solvent.

The development time is not particularly limited as long as the coating film of the unexposed portion is sufficiently dissolved, and is preferably 10 to 300 seconds, more preferably 20 to 120 seconds, and still more preferably 20 to 90 seconds.

The temperature of the developer is preferably 0°C to 50°C, more preferably 15°C to 35°C, and still more preferably 20°C to 30°C.

A type of a developer used in the development treatment is not particularly limited, but an alkaline developer is desirable.

The alkali developer is preferably an alkaline aqueous solution prepared by dissolving an alkaline compound in water so that the concentration of the alkaline compound is 0.001% to 10% by mass (preferably 0.01% to 5% by mass).

Examples of the alkaline compound include sodium hydroxide, potassium hydroxide, sodium carbonate, sodium silicate, sodium metasilicate, aqueous ammonia, ethylamine, diethylamine, dimethylethanolamine, tetramethylammonium hydroxide, tetraethylammonium hydroxide, tetrapropylammonium hydroxide, tetrabutylammonium hydroxide, benzyltrimethylammonium hydroxide, choline, pyrrole, piperidine, and 1,8-diazabicyclo[5.4.0]-7-undecene (among which organic alkalis are preferable.).

<Step X4>

The step X4 is a step of rinsing the substrate with a coating film obtained through the step X3 with a chemical liquid to form a pattern containing magnetic particles.

In the step X4, a chemical liquid is used as the rinsing liquid. The chemical liquid is as described above.

It is also preferable that after the rinsing treatment using the chemical liquid is carried out, a rinsing treatment using pure water is further carried out.

A rinsing method is not particularly limited, and examples thereof include a method in which the rinsing liquid is continuously jetted onto the substrate rotated at a constant rate (a spin coating method), a method in which the substrate is immersed in a tank filled with the rinsing liquid for a certain period of time (a dipping method), and a method in which the rinsing liquid is sprayed on the surface of the substrate (a spraying method).

The rinsing time is not particularly limited, but is preferably 10 to 300 seconds, more preferably 20 to 120 seconds,

and still more preferably 20 to 90 seconds.

The temperature of the rinsing liquid is preferably 0°C to 50°C, more preferably 15°C to 35°C, and still more preferably 20°C to 30°C.

<Step X5>

The step X5 is a step of rinsing the substrate with a coating film obtained through the step X3 with a chemical liquid and further performing a heating treatment on the substrate having a coating film rinsed with a chemical liquid to form a pattern containing magnetic particles.

In the step X5, a chemical liquid is used as the rinsing liquid. The chemical liquid is as described above.

It is also preferable that a rinsing treatment with pure water is further performed after the rinsing treatment using the chemical liquid is performed and before the heating treatment is performed.

A rinsing method is not particularly limited, and examples thereof include a method in which the rinsing liquid is continuously jetted onto the substrate rotated at a constant rate (a spin coating method), a method in which the substrate is immersed in a tank filled with the rinsing liquid for a certain period of time (a dipping method), and a method in which the rinsing liquid is sprayed on the surface of the substrate (a spraying method).

The rinsing time is not particularly limited, but is preferably 10 to 300 seconds, more preferably 20 to 120 seconds, and still more preferably 20 to 90 seconds.

The temperature of the rinsing liquid is preferably 0°C to 50°C, more preferably 15°C to 35°C, and still more preferably 20°C to 30°C.

After the rinsing treatment, a heating treatment is carried out on a substrate having a coating film rinsed with a chemical liquid.

The heating temperature is preferably 80°C to 150°C, more preferably 80°C to 140°C, and still more preferably 80°C to 130°C.

The heating time is preferably 10 to 1,000 seconds, more preferably 10 to 180 seconds, and even more preferably 30 to 120 seconds.

The heating can be carried out using a unit included in an ordinary exposure machine and/or development machine, and may also be performed using a hot plate or the like.

<Step X6>

In a case where the composition A is used, the step X4 may have a step of performing a heating step (step X6) on a substrate having a coating film rinsed with a chemical liquid after the rinsing treatment. By performing the step X6, the curing reaction is promoted, and a pattern having higher resistance can be formed.

The upper limit value of the heating temperature is preferably 240°C or lower and more preferably 220°C or lower. The lower limit value is preferably 50°C or higher and more preferably 100°C or higher.

The heating can be performed continuously or batchwise using a heating unit such as a hot plate, a convection oven (hot air circulation type dryer), and a high-frequency heater.

<Step X7>

It is also preferable that a heating treatment (step X7) is performed on the coating film which has been subjected to the exposure treatment after the step X2 is performed and before the step X3 is performed.

The heating temperature is preferably 80°C to 150°C, more preferably 80°C to 140°C, and still more preferably 80°C to 130°C.

The heating time is preferably 10 to 1,000 seconds, more preferably 10 to 180 seconds, and even more preferably 30 to 120 seconds.

The heating can be carried out using a unit included in an ordinary exposure machine and/or development machine, and may also be performed using a hot plate or the like.

[Pattern forming method of second aspect]

The pattern forming method of the second aspect includes the following steps Y1 to Y3.

Step Y1: step of applying a composition A containing magnetic particles, a resin, a polymerizable compound, and a solvent onto a substrate by an ink jet method or a screen method to form a patterned coating film
Step Y2: step of subjecting the coating film to a curing treatment
Step Y3: step of washing the substrate having the cured coating film (patterned cured film) with a chemical liquid to

form a pattern containing magnetic particles

Hereinafter, the steps Y1 to Y3 will be described.

<Step Y1>

The step Y1 is a step of applying a composition including each component such as magnetic particles onto a substrate to form a coating film. The composition will be described in detail in the latter part.
Examples of the composition and the substrate to be used include the same ones as the composition and the substrate used in the step X1 of the pattern forming method according to the first aspect described above.
In the step Y1, a patterned coating film of a composition containing each component such as magnetic particles is formed on a substrate by an inkjet method or a screen method.
The lower limit value of the thickness of the coating film is, for example, preferably 1 μm or more, more preferably 10 μm or more, and still more preferably 15 μm or more. In addition, the upper limit value is preferably 10,000 μm or less, more preferably 1,000 μm or less, still more preferably 800 μm or less, and still more preferably 300 μm or less.

<Step Y2>

The step Y2 is a step of subjecting the patterned coating film obtained in the step Y1 to a curing treatment.
Examples of the curing treatment include an exposure treatment and a heating treatment, and an exposure treatment is preferable.
In a case where the curing treatment is the exposure treatment, a heating treatment (pre-baking) may be performed on the coating film disposed on the substrate after the step Y1 is performed and before the step Y2 is performed.
A heating temperature is, for example, preferably 50°C to 140°C and more preferably 80°C to 120°C.
The heating time is, for example, preferably 30 to 1,800 seconds, more preferably 60 to 1,000 seconds, and still more preferably 60 to 800 seconds.
In a case where the curing treatment is an exposure treatment, the method of the exposure treatment is the same as the method of the exposure treatment described in the step X2 of the pattern forming method of the first aspect.

<Step Y3>

The step Y3 is a step of washing the substrate having the patterned cured film obtained in the step Y2 with a chemical liquid to form a pattern containing magnetic particles.
In the step Y3, a chemical liquid is used as the washing solution. The chemical liquid is as described above.
It is also preferable that a washing treatment using pure water is further carried out after carrying out the washing treatment using the chemical liquid.
The washing method is not particularly limited, and examples thereof include a method of continuously jetting a washing solution onto a substrate that is being rotated at a constant speed (a spin coating method), a method of immersing a substrate in a tank filled with a washing solution for a certain period of time (a dipping method), and a method of spraying a washing solution onto a substrate surface (a spray method).
The washing solution time is not particularly limited, but is preferably 10 to 300 seconds, more preferably 20 to 120 seconds, and still more preferably 20 to 90 seconds.
The temperature of the washing solution liquid is preferably 0°C to 50°C, more preferably 15°C to 35°C, and still more preferably 20°C to 30°C.

<Step Y4>

In a case where the step Y2 is an exposure treatment, it is also preferable that a heating treatment (step Y4) is performed on the coating film which has been subjected to the exposure treatment after the step Y2 is performed and before the step Y3 is performed.
The heating temperature is preferably 80°C to 150°C, more preferably 80°C to 140°C, and still more preferably 80°C to 130°C.
The heating time is preferably 10 to 1,000 seconds, more preferably 10 to 180 seconds, and even more preferably 30 to 120 seconds.
The heating can be carried out using a unit included in an ordinary exposure machine and/or development machine, and may also be performed using a hot plate or the like.

<Step Y5>

The step Y3 may have a step of performing a heating step (step Y5) on the substrate having the coating film rinsed with the chemical liquid after the rinsing treatment. By performing the step Y5, the washing solution remaining between the patterns and inside the patterns can be removed.

The upper limit value of the heating temperature is preferably 240°C or lower and more preferably 220°C or lower. The lower limit value is preferably 50°C or higher and more preferably 100°C or higher.

The heating can be performed continuously or batchwise using a heating unit such as a hot plate, a convection oven (hot air circulation type dryer), and a high-frequency heater.

[Composition]

Hereinafter, the composition (the composition A and the composition B) that can be used in the above-described pattern forming method will be described in detail.

<<Composition A>>

<Magnetic particles>

The magnetic particles contain a metal atom.

In the present specification, examples of the above-described metal atom also include metalloid atoms such as boron, silicon, germanium, arsenic, antimony, and tellurium.

The metal atom may be contained in the magnetic particles as an alloy containing a metal element (preferably a magnetic alloy), a metal oxide (preferably a magnetic oxide), a metal nitride (preferably a magnetic oxide), or a metal carbide (preferably a magnetic carbide).

The content of the above-described metal atom with respect to the total mass of the magnetic particles is preferably 50% to 100% by mass, more preferably 75% to 100% by mass, and still more preferably 95% to 100% by mass.

The metal atom is not particularly limited, and the magnetic particles preferably contain at least one metal atom selected from the group consisting of Fe, Ni, and Co.

The content of at least one metal atom selected from the group consisting of Fe, Ni, and Co (the total content of a plurality of types of metal atoms in a case where the plurality of types of metal atoms are contained) is preferably 50% by mass or more, more preferably 60% by mass or more, and still more preferably 70% by mass or more with respect to the total mass of the metal atoms in the magnetic particles. The upper limit value of the content of the metal element is not particularly limited, and is, for example, 100% by mass or less, preferably 98% by mass or less, and more preferably 95% by mass or less.

The magnetic particles may contain a material other than Fe, Ni, and Co, and specific examples thereof include Al, Si, S, Sc, Ti, V, Cu, Y, Mo, Rh, Pd, Ag, Sn, Sb, Te, Ba, Ta, W, Re, Au, Bi, La, Ce, Pr, Nd, P, Zn, Zr, Mn, Cr, Nb, Pb, Ca, B, C, N, and O.

In a case where the magnetic particles contain a metal atom other than Fe, Ni, and Co, it is preferable that the magnetic particles contain one or more metal atoms selected from the group consisting of Si, Cr, B, and Mo.

Examples of the magnetic particles include alloys such as a Fe-Co-based alloy (preferably Permendur), a Fe-Ni-based alloy (for example, Permalloy), a Fe-Zr-based alloy, a Fe-Mn-based alloy, a Fe-Si-based alloy, a Fe-Al-based alloy, a Ni-Mo-based alloy (preferably Supermalloy), a Fe-Ni-Co-based alloy, a Fe-Si-Cr-based alloy, a Fe-Si-B-based alloy, a Fe-Si-Al-based alloy (preferably Sendust), a Fe-Si-B-C-based alloy, a Fe-Si-B-Cr-based alloy, a Fe-Si-B-Cr-C-based alloy, a Fe-Co-Si-B-based alloy, a Fe-Si-B-Nb-based alloy, a Fe nanocrystalline alloy, a Fe-based amorphous alloy, and a Co-based amorphous alloy, as well as ferrites such as a spinel ferrite (preferably a Ni-Zn-based ferrite or a Mn-Zn-based ferrite) and a hexagonal ferrite (preferably a barium ferrite or a magnetoplumbite type hexagonal ferrite). The alloy may be amorphous.

The hexagonal ferrite which is preferable from the viewpoint of radio wave absorption performance may be, for example, a substituted magnetoplumbite type hexagonal ferrite in which some of iron atoms in hexagonal ferrite are substituted with aluminum atoms. Further, a Ba-Fe-Al-based alloy, a Ca-Fe-Al-based alloy, or a Pb-Fe-Al-based alloy in which a part of the alloy is substituted with Ba, Ca, or Pb is more preferable from the viewpoint of absorption of radio waves in a high frequency band.

The magnetic particles may be used alone or in combination of two or more thereof.

The magnetic particles may have a surface layer provided on the surface thereof. In a case where the magnetic particles have a surface layer in this manner, the magnetic particles can be endowed with a function according to the material of the surface layer.

The surface layer may be, for example, an inorganic layer or an organic layer.

The thickness of the surface layer is not particularly limited and is preferably 3 to 1000 nm from the viewpoint that the function of the surface layer is more exhibited.

The average primary particle diameter of the magnetic particles is preferably 20 to 1000 nm. The average primary particle diameter of the magnetic particles is more preferably 20 to 500 nm from the viewpoint of dispersion in a composition and pattern resolution.

The particle diameter of the primary particle of the magnetic particle is measured in such a manner that the magnetic particle is imaged with a transmission electron microscope at an imaging magnification of 100,000x, the magnetic particle image is printed on a printing paper at a total magnification of 500,000x, and in the obtained particle image, the contour of the particle (primary particle) is traced with a digitizer and then the diameter of a circle having the same area as the traced region (circular area phase diameter) is calculated. Here, the primary particles refer to independent particles that are not aggregated. The imaging using a transmission electron microscope is carried out by a direct method using a transmission electron microscope at an acceleration voltage of 300 kV. The observation and measurement with the transmission electron microscope can be carried out using, for example, a transmission electron microscope H-9000 (manufactured by Hitachi Ltd.) and an image analysis software KS-400 (manufactured by Carl Zeiss AG). The particle diameters of the primary particles of at least 100 magnetic particles measured above are arithmetically averaged to calculate the average primary particle diameter.

The shape of the magnetic particle is not particularly limited, and may be any of a plate shape, an elliptical shape, a spherical shape, and an amorphous shape.

The content of the magnetic particles is preferably 20% to 99% by mass, more preferably 20% to 80% by mass, and still more preferably 20% to 60% by mass with respect to the total mass of the composition.

The content of the magnetic particles is preferably 20% to 99% by mass, more preferably 30% to 80% by mass, and still more preferably 30% to 70% by mass with respect to the total solid content of the composition.

[Polymerizable compound]

The polymerizable compound is a compound having a polymerizable group (photopolymerizable compound), examples of which include a compound containing a group containing an ethylenically unsaturated bond (hereinafter, also simply referred to as an "ethylenically unsaturated group") and a compound having an epoxy group and/or an oxetanyl group, with a compound containing an ethylenically unsaturated group being preferred.

The composition preferably contains a low-molecular-weight compound containing an ethylenically unsaturated group as the polymerizable compound.

The polymerizable compound is preferably a compound containing one or more ethylenically unsaturated bonds, more preferably a compound containing two or more ethylenically unsaturated bonds, still more preferably a compound containing three or more ethylenically unsaturated bonds, and particularly preferably a compound containing five or more ethylenically unsaturated bonds. The upper limit is, for example, 15 or less. Examples of the ethylenic unsaturated group include a vinyl group, a (meth)allyl group, and a (meth)acryloyl group.

As the polymerizable compound, for example, it is possible to use the compounds described in paragraph "0050" of JP2008-260927A and paragraph "0040" of JP2015-068893A, and what are described in the paragraphs are incorporated into the present specification.

The polymerizable compound may be in any chemical form such as a monomer, a prepolymer, an oligomer, a mixture of these, and a multimer of these.

The polymerizable compound is preferably a (meth)acrylate compound having 3 to 15 functionalities, and more preferably a (meth)acrylate compound having 3 to 6 functionalities.

As the polymerizable compound, a compound that contains one or more ethylenically unsaturated groups and has a boiling point of 100°C or higher under normal pressure is also preferable. Reference can be made to, for example, the compounds described in paragraph 0227 of JP2013-029760A and paragraphs 0254 to 0257 of JP2008-292970A, the contents of which are incorporated into the present specification.

As the polymerizable compound, dipentaerythritol triacrylate (KAYARAD D-330 as a commercially available product; manufactured by Nippon Kayaku Co., Ltd.), dipentaerythritol tetraacrylate (KAYARAD D-320 as a commercially available product; manufactured by Nippon Kayaku Co., Ltd.), dipentaerythritol penta(meth)acrylate (KAYARAD D-310 as a commercially available product; manufactured by Nippon Kayaku Co., Ltd.), dipentaerythritol hexa(meth)acrylate (KAYARAD DPHA as a commercially available product; manufactured by Nippon Kayaku Co., Ltd., A-DPH-12E; manufactured by SHIN-NAKAMURA CHEMICAL CO, LTD.), and the structure in which these (meth)acryloyl groups are mediated by an ethylene glycol residue or a propylene glycol residue (for example, SR454 and SR499 commercially available from Sartomer Company Inc.) are preferable. Oligomer types thereof can also be used. In addition, NK ESTER A-TMMT (pentaerythritol tetraacrylate, manufactured by Shin-Nakamura Chemical Co., Ltd.) KAYARAD RP-1040, KAYARAD DPEA-12LT, KAYARAD DPHA LT, KAYARAD RP-3060, and KAYARAD DPEA-12 (all trade names, manufactured by Nippon Kayaku Co., Ltd.), and the like may be used.

The polymerizable compound may have an acid group such as a carboxylic acid group, a sulfonic acid group, or a phosphoric acid group. The polymerizable compound containing an acid group is preferably an ester of an aliphatic polyhydroxy compound and an unsaturated carboxylic acid, more preferably a polymerizable compound obtained by reacting an unreacted hydroxyl group of an aliphatic polyhydroxy compound with a non-aromatic carboxylic anhydride such that an acid group is added, and even more preferably an ester of the aforementioned polymerizable compound having pentaerythritol and/or dipentaerythritol as the aliphatic polyhydroxy compound.

The acid value of the polymerizable compound containing an acid group is preferably 0.1 to 40 mgKOH/g and more preferably 5 to 30 mgKOH/g. In a case where the acid value of the polymerizable compound is 0.1 mgKOH/g or more, development and dissolution characteristics are excellent. In a case where the acid value is 40 mgKOH/g or less, this is advantageous in terms of manufacturing and/or handling. Further, the photopolymerization performance is good, and the curability is excellent.

As the polymerizable compound, a compound containing a caprolactone structure is also a preferred aspect.

The compound containing a caprolactone structure is not particularly limited as long as the caprolactone structure is contained in the molecule; however, examples thereof include an ε-caprolactone-modified polyfunctional (meth)acrylate obtained by esterifying a polyhydric alcohol such as trimethylolethane, ditrimethylolethane, trimethylolpropane, ditrimethylolpropane, pentaerythritol, dipentaerythritol, tripentaerythritol, glycerin, diglycerol, or trimethylolmelamine with (meth)acrylic acid and ε-caprolactone. Among these, a compound containing a caprolactone structure represented by the following Formula (Z-1) is preferable.

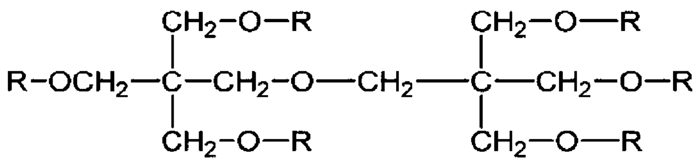

(Z-1)

In Formula (Z-1), all six R's are groups represented by Formula (Z-2), or one to five among the six R's are groups represented by Formula (Z-2) and the others are groups represented by Formula (Z-3).

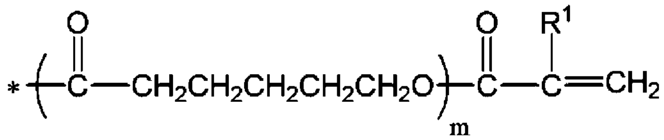

(Z-2)

In Formula (Z-2), $R^1$ represents a hydrogen atom or a methyl group, m represents a number of 1 or 2, and "*" represents a bonding site.

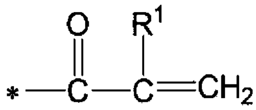

(Z-3)

In Formula (Z-3), $R^1$ represents a hydrogen atom or a methyl group, and "*" represents a bonding site.

As the polymerizable compound, a compound represented by the following Formula (Z-4) or (Z-5) can also be used.

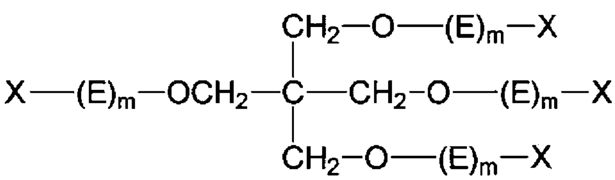

(Z-4)

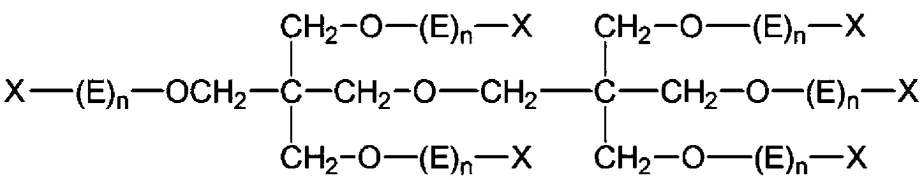

(Z-5)

In Formulae (Z-4) and (Z-5), E represents $-((CH_2)_yCH_2O)-$ or $-((CH_2)_yCH(CH_3)O)-$, y represents an integer of 0 to 10, and X represents a (meth)acryloyl group, a hydrogen atom, or a carboxylic acid group.

In Formula (Z-4), the total number of (meth)acryloyl groups is 3 or 4, m represents an integer of 0 to 10, and the sum of m's is an integer of 0 to 40.

In Formula (Z-5), the total number of (meth)acryloyl groups is 5 or 6, n represents an integer of 0 to 10, and the sum of n's is an integer of 0 to 60.

In Formula (Z-4), m is preferably an integer of 0 to 6 and more preferably an integer of 0 to 4.

In addition, the total number of m's is preferably an integer of 2 to 40, more preferably an integer of 2 to 16, and still more preferably an integer of 4 to 8.

In Formula (Z-5), n is preferably an integer of 0 to 6 and more preferably an integer of 0 to 4.

In addition, the total number of n's is preferably an integer of 3 to 60, more preferably an integer of 3 to 24, and still more preferably an integer of 6 to 12.

In addition, $-((CH_2)_yCH_2O)-$ or $-((CH_2)_yCH(CH_3)O)-$ in Formula (Z-4) or Formula (Z-5) preferably has a form in which the terminal on the oxygen atom side is bonded to X.

The compound represented by Formula (Z-4) or Formula (Z-5) may be used alone or in combination of two or more thereof. In particular, aspects such as a form in which all of six X's in Formula (Z-5) are acryloyl groups, and a mixture of a compound in which all of six X's in Formula (Z-5) are acryloyl groups and a compound in which at least one among the six X's is a hydrogen atom are preferable. With such a configuration, the developability can be further improved.

The total content of the compound represented by Formula (Z-4) or Formula (Z-5) in the polymerizable compound is preferably 20% by mass or more, and more preferably 50% by mass or more.

Among the compounds represented by Formula (Z-4) or Formula (Z-5), a pentaerythritol derivative and/or a dipentaerythritol derivative is more preferable.

The polymerizable compound may contain a cardo skeleton.

As the polymerizable compound containing a cardo skeleton, a polymerizable compound containing a 9,9-bisarylfluorene skeleton is preferable.

The content of ethylenically unsaturated groups in the polymerizable compound (the content means a value obtained by dividing the number of ethylenically unsaturated groups in the polymerizable compound by the molecular weight (g/mol) of the polymerizable compound) is preferably 5.0 mmol/g or more. The upper limit thereof is not particularly limited, but is generally 20.0 mmol/g or less.

The content of the polymerizable compound in the composition is not particularly limited, and is preferably 1% to 40% by mass, more preferably 5% to 30% by mass, and still more preferably 10% to 25% by mass with respect to the total mass content of the composition.

The content of the polymerizable compound in the composition is not particularly limited, and is preferably 1% to 40% by mass, more preferably 5% to 30% by mass, and still more preferably 10% to 25% by mass with respect to the total solid content of the composition.

The composition may contain materials other than the above-mentioned magnetic particles and polymerizable compound.

<Resin>

The composition may contain a resin.

Examples of the resin include a (meth)acrylic resin, an epoxy resin, an ene-thiol resin, a polycarbonate resin, a polyether resin, a polyarylate resin, a polysulfone resin, a polyethersulfone resin, a polyphenylene resin, a polyarylene ether phosphine oxide resin, a polyimide resin, a polyamide imide resin, a polyolefin resin, a cyclic olefin resin, a polyester resin, a styrene resin, and a phenoxy resin.

One type of these resins may be used alone, or two or more types of these resins may be used in admixture.

A suitable aspect of the resin may be, for example, a resin having an unsaturated double bond (for example, an ethylenically unsaturated double bond) and a polymerizable group such as an epoxy group or an oxetanyl group.

In addition, a suitable aspect of the resin may be, for example, a resin having an acid group, a basic group, or an amide group. The resin having an acid group, a basic group, or an amide group tends to exhibit a function as a dispersant for dispersing magnetic particles.

Examples of the acid group include a carboxy group, a phosphoric acid group, a sulfo group, and a phenolic hydroxyl group, among which a carboxy group is preferable.

Examples of the basic group include an amino group (a group obtained by removing one hydrogen atom from ammonia, a primary amine, or a secondary amine) and an imino group.

Above all, the resin preferably has a carboxy group or an amide group.

In a case where the resin has an acid group, the acid value of the resin is preferably 10 to 500 mgKOH/g and more preferably 30 to 400 mgKOH/g.

As the resin, from the viewpoint of improving the dispersibility of the resin in the composition, it is preferable to use a resin having a solubility in a solvent of 10 g/L or more, and it is more preferable to use a resin having a solubility in a solvent of 20 g/L or more.
The upper limit value of the solubility of the resin in a solvent is preferably 2,000 g/L or less and more preferably 1,000 g/L or less.
The solubility of the resin in a solvent means a dissolution amount (g) of the resin in 1 L of the solvent at 25°C.
The content of the resin is preferably 0.1% to 40% by mass, more preferably 1% to 30% by mass, and still more preferably 10% to 30% by mass with respect to the total mass of the composition.
The content of the resin is preferably 0.1% to 40% by mass, more preferably 1% to 35% by mass, and still more preferably 10% to 35% by mass with respect to the total mass of the composition.
A suitable aspect of the resin may be, for example, a resin that functions as a dispersant for dispersing magnetic particles in the composition (hereinafter, also referred to as a "dispersion resin"). The effect of the present invention is more excellent by using the dispersion resin.

(Resin having repeating unit containing graft chain)

The dispersion resin may be, for example, a resin having a repeating unit containing a graft chain (hereinafter, also referred to as "resin A"). In this regard, the resin A can be used for purposes other than functioning as a dispersant.
In a case where the composition contains the resin A, the content of the resin A is preferably 0.1% to 40% by mass, more preferably 0.5% to 35% by mass, and still more preferably 1% to 35% by mass with respect to the total mass of the composition.
In a case where the composition contains the resin A, the content of the resin A is preferably 0.1% to 40% by mass, more preferably 0.5% to 35% by mass, and still more preferably 1% to 35% by mass with respect to the solid content of the composition.

· Repeating unit containing graft chain

In the repeating unit containing a graft chain, a longer graft chain leads to a higher steric repulsion effect, which improves the dispersibility of magnetic particles. On the other hand, in a case where the graft chain is too long, the adsorption power to the magnetic particles tends to decrease, and therefore the dispersibility of the magnetic particles tends to decrease. For this reason, the graft chain preferably has 40 to 10000 atoms excluding hydrogen atoms, more preferably 50 to 2000 atoms excluding hydrogen atoms, and still more preferably 60 to 500 atoms excluding hydrogen atoms.
Here, the graft chain refers to a portion extending from a root of a main chain (an atom in a group branching off from the main chain which is bonded to the main chain) to a terminal of the group branching off from the main chain.
In addition, the graft chain preferably contains a polymer structure, and examples of such a polymer structure include a poly(meth)acrylate structure (for example, a poly(meth)acrylic structure), a polyester structure, a polyurethane structure, a polyurea structure, a polyamide structure, and a polyether structure.
In order to improve the interactive properties between the graft chain and the solvent and thereby enhance the dispersibility of the magnetic particles, the graft chain is preferably a graft chain containing at least one selected from the group consisting of a polyester structure, a polyether structure, and a poly(meth)acrylate structure, and more preferably a graft chain containing at least one of a polyester structure or a polyether structure.
The resin A may be a resin obtained using a macromonomer having a graft chain (monomer which has a polymer structure and constitutes a graft chain by being bonded to the main chain of).
The macromonomer having a graft chain (monomer which has a polymer structure and constitutes a graft chain by being bonded to the main chain of) is not particularly limited, but a macromonomer including a reactive double bond group can be suitably used.
As commercially available macromonomers which correspond to the above-described repeating unit having a graft chain and are suitably used for the synthesis of the resin A, AA-6, AA-10, AB-6, AS-6, AN-6, AW-6, AA-714, AY-707, AY-714, AK-5, AK-30, and AK-32 (all are trade names, manufactured by TOAGOSEI CO., LTD.), and BLEMMER PP-100, BLEMMER PP-500, BLEMMER PP-800, BLEMMER PP-1000, BLEMMER 55-PET-800, BLEMMER PME-4000, BLEMMER PSE-400, BLEMMER PSE-1300, and BLEMMER 43PAPE-600B (all are trade names, manufactured by NOF CORPORATION.) are used.
The resin A preferably includes at least one structure selected from the group consisting of polymethyl acrylate, polymethyl methacrylate, and a cyclic or chain-like polyester; more preferably has at least one structure selected from the group consisting of polymethyl acrylate, polymethyl methacrylate, and a chain-like polyester; and still more preferably has at least one structure selected from the group consisting of a polymethyl acrylate structure, a polymethyl methacrylate structure, a polycaprolactone structure, and a polyvalerolactone structure. The resin A may include the above-described

structure alone, or may include a plurality of the above-described structures.

Here, the polycaprolactone structure refers to a structure including a structure, which is obtained by ring opening of ε-caprolactone, as a repeating unit. The polyvalerolactone structure refers to a structure including a structure, which is obtained by ring opening of δ-valerolactone, as a repeating unit.

In a case where the resin A includes repeating units represented by Formula (1) and Formula (2), which will be described later, in which each of j and k is 5, the above-described polycaprolactone structure can be introduced into the resin A.

In addition, in a case where the resin A includes repeating units represented by Formula (1) and Formula (2), which will be described later, in which each of j and k is 4, the above-described polyvalerolactone structure can be introduced into the resin.

In addition, in a case where the resin A includes a repeating unit represented by Formula (4), which will be described later, in which $X^5$ is a hydrogen atom and $R^4$ is a methyl group, the above-described polymethyl acrylate structure can be introduced into the resin A.

In addition, in a case where the resin A includes a repeating unit represented by Formula (4), which will be described later, in which $X^5$ is a methyl group and $R^4$ is a methyl group, the above-described polymethyl methacrylate structure can be introduced into the resin A.

The resin A preferably contains a repeating unit represented by any one of Formula (1) to Formula (4), and more preferably a repeating unit represented by any one of Formula (1A), Formula (2A), Formula (3A), Formula (3B), and Formula (4), as the repeating unit containing a graft chain.

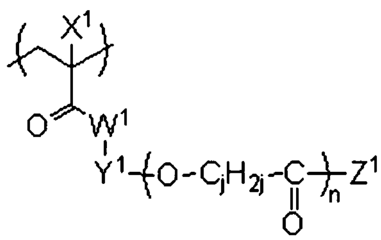 (1)

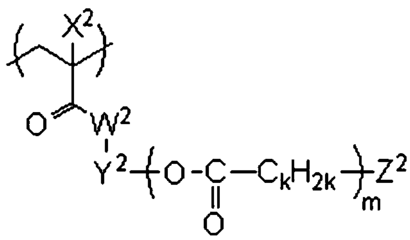 (2)

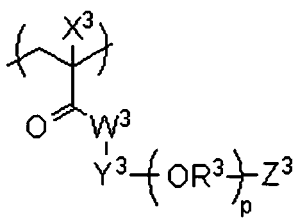 (3)

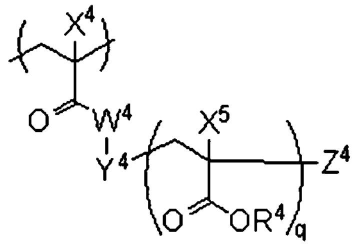 (4)

In Formulae (1) to (4), $W^1$, $W^2$, $W^3$, and $W^4$ each independently represent an oxygen atom or NH. $W^1$, $W^2$, $W^3$, and $W^4$ are preferably an oxygen atom.

In Formulae (1) to (4), $X^1$, $X^2$, $X^3$, $X^4$, and $X^5$ each independently represent a hydrogen atom or a monovalent organic group. From the viewpoint of restriction on synthesis, $X^1$, $X^2$, $X^3$, $X^4$, and $X^5$ are each independently preferably a hydrogen atom or an alkyl group having 1 to 12 carbon atoms (the number of carbon atoms), more preferably a hydrogen atom or a methyl group, and still more preferably a methyl group.

In Formulae (1) to (4), $Y^1$, $Y^2$, $Y^3$, and $Y^4$ each independently represent a divalent linking group, and the linking group has no particular restriction on a structure. Specific examples of the divalent linking groups represented by $Y^1$, $Y^2$, $Y^3$, and $Y^4$ include linking groups represented by the following (Y-1) to (Y-21). In the following structures, A and B each mean a bonding site bonded to the left terminal group and the right terminal group in Formulae (1) to (4). Among the structures shown below, from the viewpoint of simplicity of synthesis, (Y-2) or (Y-13) is more preferable.

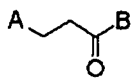
(Y-1)

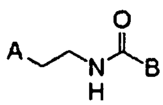
(Y-2)

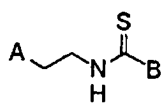
(Y-3)

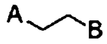
(Y-4)

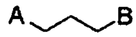
(Y-5)

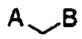
(Y-6)

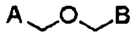
(Y-7)

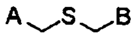
(Y-8)

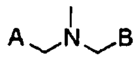
(Y-9)

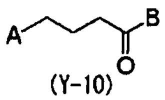
(Y-10)

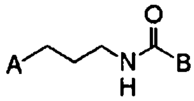
(Y-11)

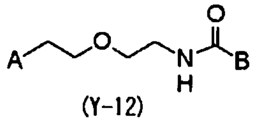
(Y-12)

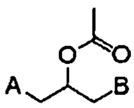
(Y-13)

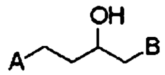
(Y-14)

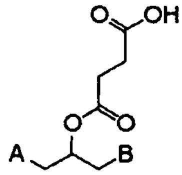
(Y-15)

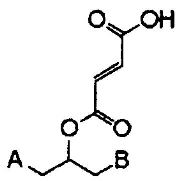
(Y-16)

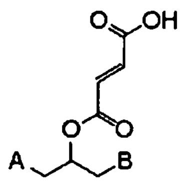
(Y-17)

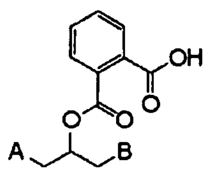
(Y-18)

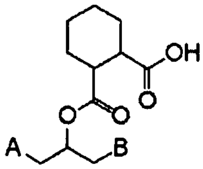
(Y-19)

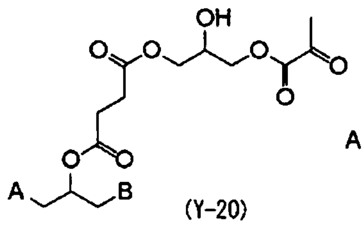
(Y-20)

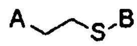
(Y-21)

In Formula (1) to Formula (4), $Z^1$, $Z^2$, $Z^3$, and $Z^4$ each independently represent an organic group. The structure of the organic group is not particularly limited, and specific examples of the organic group include an alkyl group, an alkyl group containing -O-, an alkoxy group, an aryloxy group, a heteroaryloxy group, an alkylthioether group, an arylthioether group, a heteroarylthioether group, and an amino group. The above-mentioned substituent may be further substituted with a substituent (for example, a hydroxyl group or a (meth)acryloyloxy group).

Among these groups, particularly from the viewpoint of improving dispersibility, the organic group represented by $Z^1$, $Z^2$, $Z^3$, and $Z^4$ is preferably a group having a steric repulsion effect, more preferably an alkyl group having 5 to 24 carbon atoms or an alkoxy group having 5 to 24 carbon atoms, and still more preferably a branched alkyl group having 5 to 24 carbon atoms, a cyclic alkyl group having 5 to 24 carbon atoms, or an alkoxy group having 5 to 24 carbon atoms. The alkyl group included in the alkoxy group may be linear, branched, or cyclic.

In Formulae (1) to (4), n, m, p, and q are each independently an integer of 1 to 500.

In addition, in Formulae (1) and (2), j and k each independently represent an integer of 2 to 8. Each of j and k in Formulae (1) and (2) is preferably an integer of 4 to 6, and more preferably 5.

In addition, in Formula (1) and Formula (2), n and m are each preferably an integer of 10 or more and more preferably an integer of 20 or more. In addition, in a case where the resin A contains a polycaprolactone structure and a polyvalerolactone structure, the sum of the number of repetitions of the polycaprolactone structure and the number of repetitions of the polyvalerolactone is preferably an integer of 10 or more, and more preferably an integer of 20 or more.

In Formula (3), $R^3$ represents a branched or linear alkylene group, and is preferably an alkylene group having 1 to

10 carbon atoms and more preferably an alkylene group having 2 or 3 carbon atoms. In a case where p is 2 to 500, a plurality of $R^3$'s may be the same or different from each other.

In Formula (4), $R^4$ represents a hydrogen atom or a monovalent organic group, and the structure of the monovalent organic group is not particularly limited. As $R^4$, a hydrogen atom, an alkyl group, an aryl group, or a heteroaryl group is preferable, and a hydrogen atom or an alkyl group is more preferable. In a case where $R^4$ is an alkyl group, as the alkyl group, a linear alkyl group having 1 to 20 carbon atoms, a branched alkyl group having 3 to 20 carbon atoms, or a cyclic alkyl group having 5 to 20 carbon atoms is preferable, a linear alkyl group having 1 to 20 carbon atoms is more preferable, and a linear alkyl group having 1 to 6 carbon atoms is still more preferable. In a case where q in Formula (4) is 2 to 500, a plurality of $X^5$'s and a plurality of $R^4$'s in the graft chain may be the same or different from each other, respectively.

The resin A may contain two or more kinds of repeating units having different structures and having a graft chain. That is, the molecule of the resin A may contain repeating units having different structures and represented by Formula (1) to Formula (4), and in a case where n, m, p, and q in Formula (1) to Formula (4) each represent an integer of 2 or more, in Formula (1) and Formula (2), the side chain may contain a structure in which j and k are different from each other, and in Formula (3) and Formula (4), a plurality of $R^3$'s, a plurality of $R^4$'s, and a plurality of $X^5$'s present in the molecule each may be the same as or different from each other.

The repeating unit represented by Formula (1) is more preferably a repeating unit represented by Formula (1A).

In addition, the repeating unit represented by Formula (2) is more preferably a repeating unit represented by Formula (2A).

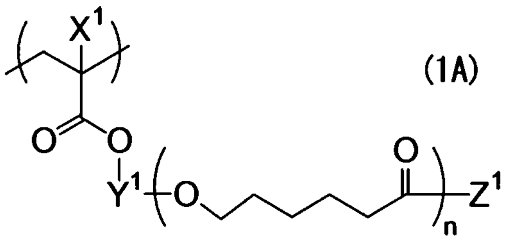

(1A)

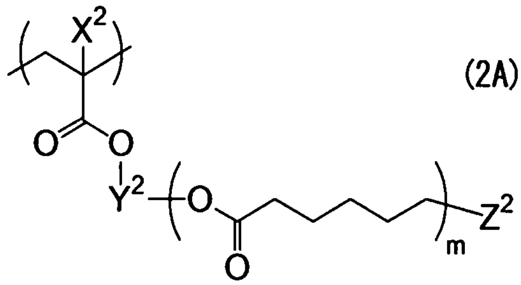

(2A)

$X^1$, $Y^1$, $Z^1$, and n in Formula (1A) have the same definitions as $X^1$, $Y^1$, $Z^1$, and n in Formula (1), and preferred ranges thereof are also the same. $X^2$, $Y^2$, $Z^2$, and m in Formula (2A) have the same definitions as $X^2$, $Y^2$, $Z^2$, and m in Formula (2), and preferred ranges thereof are also the same.

In addition, the repeating unit represented by Formula (3) is more preferably a repeating unit represented by Formula (3A) or Formula (3B).

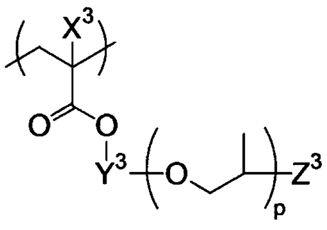

(3A)

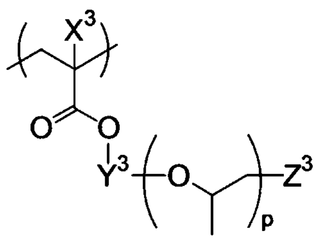

(3B)

$X^3$, $Y^3$, $Z^3$, and p in Formula (3A) or (3B) have the same definitions as $X^3$, $Y^3$, $Z^3$, and p in Formula (3), and preferred ranges thereof are also the same.

It is more preferable that the resin A contain the repeating unit represented by Formula (1A) as the repeating unit

having a graft chain.

In addition, it is also preferable that the resin A contains a repeating unit containing a polyalkyleneimine structure and a polyester structure. It is preferable that the repeating unit containing a polyalkyleneimine structure and a polyester structure contains the polyalkyleneimine structure in a main chain and the polyester structure as a graft chain.

The above-described polyalkyleneimine structure is a polymerization structure including two or more identical or different alkyleneimine chains. Specific examples of the alkyleneimine chain include alkyleneimine chains represented by Formulae (4A) and (4B).

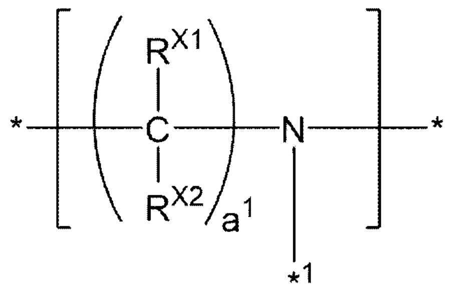

(4A)

In Formula (4A), $R^{X1}$ and $R^{X2}$ each independently represent a hydrogen atom or an alkyl group. $a^1$ represents an integer of 2 or more. $*^1$ represents a bonding position with a polyester chain, an adjacent alkyleneimine chain, or with a hydrogen atom or a substituent.

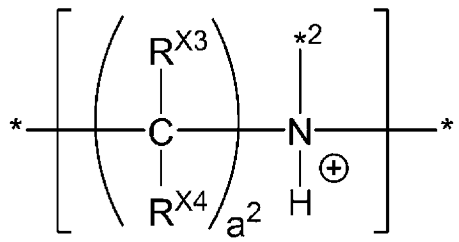

(4B)

In Formula (4B), $R^{X3}$ and $R^{X4}$ each independently represent a hydrogen atom or an alkyl group. $a^2$ represents an integer of 2 or more. The alkyleneimine chain represented by Formula (4B) is bonded to a polyester chain having an anionic group by forming a salt-crosslinked group from $N^+$ specified in Formula (4B) and the anionic group included in the polyester chain.

**[0314]** * in Formula (4A) and Formula (4B) and $*^2$ in Formula (4B) each independently represent a position where an adjacent alkyleneimine chain, or a hydrogen atom or a substituent is bonded.

Among these, * in Formula (4A) and Formula (4B) preferably represents a position where an adjacent alkyleneimine chain is bonded.

$R^{X1}$ and $R^{X2}$ in Formula (4A) and $R^{X3}$ and $R^{X4}$ in Formula (4B) each independently represent a hydrogen atom or an alkyl group.

The number of carbon atoms in the alkyl group is preferably 1 to 6 and more preferably 1 to 3.

In Formula (4A), both $R^{X1}$ and $R^{X2}$ are preferably a hydrogen atom.

In Formula (4B), both $R^{X3}$ and $R^{X4}$ are preferably a hydrogen atom.

$a^1$ in Formula (4A) and $a^2$ in Formula (4B) are not particularly limited as long as they are an integer of 2 or more. The upper limit value thereof is preferably 10 or less, more preferably 6 or less, still more preferably 4 or less, still more preferably 2 or 3, and particularly preferably 2.

In Formula (4A) and Formula (4B), * represents a bonding position with an adjacent alkyleneimine chain or with a hydrogen atom or a substituent.

Examples of the above-described substituent include a substituent such as an alkyl group (for example, an alkyl group having 1 to 6 carbon atoms). In addition, a polyester chain may be bonded as the substituent.

The alkyleneimine chain represented by Formula (4A) is preferably linked to the polyester chain at the position of $*^1$ described above. Specifically, it is preferable that a carbonyl carbon in the polyester chain is bonded at the position of $*^1$ described above.

Examples of the above-described polyester chain include a polyester chain represented by Formula (5A).

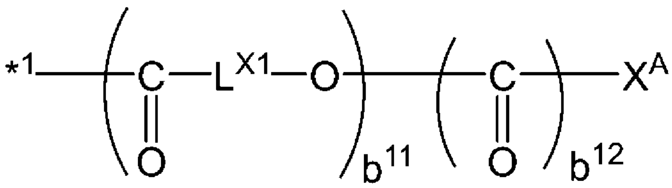

(5A)

In a case where the alkyleneimine chain is the alkyleneimine chain represented by Formula (4B), it is preferable that the polyester chain includes an anionic group (preferably, oxygen anion $O^-$), and this anionic group and $N^+$ in Formula (4B) form a salt-crosslinked group.

Examples of such a polyester chain include a polyester chain represented by Formula (5B).

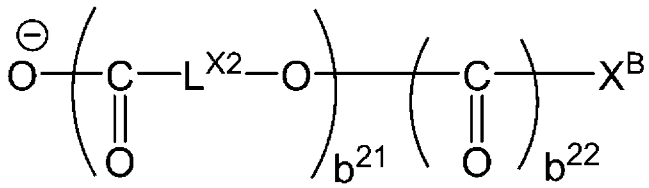

(5B)

$L^{X1}$ in Formula (5A) and $L^{X2}$ in Formula (5B) each independently represent a divalent linking group. The divalent linking group is preferably an alkylene group having 3 to 30 carbon atoms.

$b^{11}$ in Formula (5A) and $b^{21}$ in Formula (5B) each independently represent an integer of 2 or more, and the upper limit of each of $b^{11}$ and $b^{21}$ is, for example, 200 or less.

$b^{12}$ in Formula (5A) and $b^{22}$ in Formula (5B) each independently represent 0 or 1.

$X^A$ in Formula (5A) and $X^B$ in Formula (5B) each independently represent a hydrogen atom or a substituent. Examples of the substituent include an alkyl group, an alkoxy group, a polyalkyleneoxyalkyl group, and an aryl group.

The number of carbon atoms in the alkyl group (which may be linear, branched, or cyclic) and the alkyl group (which may be linear, branched, or cyclic) contained in the alkoxy group is preferably 1 to 30 and more preferably 1 to 10. In addition, the above-described alkyl group may further have a substituent, and examples of the substituent include a hydroxyl group and a halogen atom (including a fluorine atom, a chlorine atom, a bromine atom, an iodine atom, and the like).

The polyalkyleneoxyalkyl group is a substituent represented by $R^{X6}(OR^{X7})_p(O)_{q}$-. $R^{X6}$ represents an alkyl group, $R^{X7}$ represents an alkylene group, p represents an integer of 2 or more, and q represents 0 or 1.

The alkyl group represented by $R^{X6}$ has the same definitions as the alkyl group represented by $X^A$. In addition, examples of the alkylene group represented by $R^{X7}$ include a group obtained by removing one hydrogen atom from the alkyl group represented by $X^A$.

p is an integer of 2 or more, and the upper limit value thereof is, for example, 10 or less, preferably 5 or less.

Examples of the aryl group include an aryl group having 6 to 24 carbon atoms (which may be monocyclic or polycyclic).

The above-described aryl group may further have a substituent, and examples of the substituent include an alkyl group, a halogen atom, and a cyano group.

The above-described polyester chain preferably has a decyclized structure of a lactone such as ε-caprolactone, δ-caprolactone, β-propiolactone, γ-butyrolactone, δ-valerolactone, γ-valerolactone, enantholactone, β-butyrolactone, γ-hexanolactone, γ-octanolactone, δ-hexalanolactone, δ-octanolactone, δ-dodecanolactone, α-methyl-γ-butyrolactone, and lactide (which may be an L-form or a D-form), and more preferably has a decyclized structure of ε-caprolactone or δ-valerolactone.

The above-described repeating unit including a polyalkyleneimine structure and a polyester structure can be synthesized according to a synthesis method described in JP5923557B.

In the resin A, the content of the repeating unit containing a graft chain in terms of mass is preferably 2% to 100% by mass, more preferably 2% to 90% by mass, and still more preferably 5% to 30% by mass with respect to the total mass of the resin A.

· Hydrophobic repeating unit

In addition, the resin A may contain a hydrophobic repeating unit that is different from the repeating unit containing a graft chain (that is, a hydrophobic repeating unit that does not correspond to the repeating unit containing a graft chain). In this regard, in the present specification, the hydrophobic repeating unit is a repeating unit that does not have an acid group (for example, a carboxylic acid group, a sulfonic acid group, a phosphoric acid group, or a phenolic hydroxyl group).

The hydrophobic repeating unit is preferably a repeating unit derived from (corresponding to) a compound (monomer) having a ClogP value of 1.2 or more, and more preferably a repeating unit derived from a compound having a ClogP value of 1.2 to 8.

The ClogP value is a value calculated by a program "CLOGP" which is available from Daylight Chemical Information System, Inc. This program provides a value of a "calculated logP" calculated by the fragment approach of Hansch and Leo (see the literature below). The fragment approach is based on a chemical structure of a compound, and is carried out in such a manner that the chemical structure is divided into partial structures (fragments), and the logP contributions assigned to the fragments are summed up to estimate the logP value of the compound. The details of the fragment approach are described in the following literature. In the present specification, ClogP values calculated by a program CLOGP v4.82 are used.

A. J. Leo, Comprehensive Medicinal Chemistry, Vol. 4, C. Hansch, P. G. Sammnens, J. B. Taylor and C. A. Ramsden, Eds., p. 295, Pergamon Press, 1990 C. Hansch & A. J. Leo. Substituent Constants For Correlation Analysis in Chemistry and Biology. John Wiley & Sons. A. J. Leo. Calculating log Poct from structure. Chem. Rev., 93, 1281-1306, 1993.

The logP means a common logarithm of a partition coefficient P, and is a physical property value that expresses, in terms of a quantitative numerical value, how a certain organic compound is partitioned at an equilibrium in a two-phase system consisting of oil (generally 1-octanol) and water. The logP is expressed by the following expression.

$$\log P = \log(Coil/Cwater)$$

In the expression, Coil represents a molar concentration of a compound in an oil phase, and Cwater represents a molar concentration of a compound in a water phase.

In a case where a value of logP increases positively across 0, the oil solubility increases, and in a case where a value of logP increases negatively in terms of an absolute value, the water solubility increases. The value of logP is negatively correlated with the water solubility of an organic compound and is widely used as a parameter for estimating the hydrophilicity or hydrophobicity of an organic compound.

It is preferable that the resin A contain, as the hydrophobic repeating unit, one or more repeating units selected from repeating units derived from the monomers represented by the following Formulas (i) to (iii).

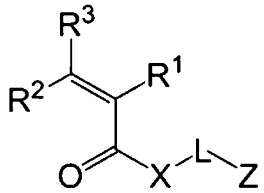

( i )

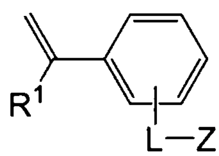

( ii )

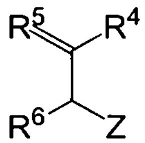

( iii )

In Formulae (i) to (iii), $R^1$, $R^2$, and $R^3$ each independently represent a hydrogen atom, a halogen atom (for example, a fluorine atom, a chlorine atom, a bromine atom, or the like), or an alkyl group (for example, a methyl group, an ethyl group, a propyl group, or the like) having 1 to 6 carbon atoms.

$R^1$, $R^2$, and $R^3$ are each preferably a hydrogen atom or an alkyl group having 1 to 3 carbon atoms, and more preferably a hydrogen atom or a methyl group. $R^2$ and $R^3$ are still more preferably a hydrogen atom.

X represents an oxygen atom (-O-) or an imino group (-NH-), and is preferably an oxygen atom.

L is a single bond or a divalent linking group. Examples of the divalent linking group include a divalent aliphatic group (for example, an alkylene group, a substituted alkylene group, an alkenylene group, a substituted alkenylene group,

an alkynylene group, or a substituted alkynylene group), a divalent aromatic group (for example, an arylene group or a substituted arylene group), a divalent heterocyclic group, an oxygen atom (-O-), a sulfur atom (-S-), an imino group (-NH-), a substituted imino group (-$NR^{31}$-, where $R^{31}$ is an aliphatic group, an aromatic group, or a heterocyclic group), a carbonyl group (-CO-), and a combination thereof.

L is preferably a single bond, an alkylene group, or a divalent linking group containing an oxyalkylene structure. The oxyalkylene structure is more preferably an oxyethylene structure or an oxypropylene structure. In addition, L may have a polyoxyalkylene structure which includes two or more repeating oxyalkylene structures. As the polyoxyalkylene structure, a polyoxyethylene structure or a polyoxypropylene structure is preferable. The polyoxyethylene structure is represented by $-(OCH_2CH_2)_n-$, and n is preferably an integer of 2 or more and more preferably an integer of 2 to 10.

Examples of Z include an aliphatic group (for example, an alkyl group, a substituted alkyl group, an unsaturated alkyl group, or a substituted unsaturated alkyl group), an aromatic group (for example, an aryl group, a substituted aryl group, an arylene group, or a substituted arylene group), a heterocyclic group, and a combination thereof. These groups may contain an oxygen atom (-O-), a sulfur atom (-S-), an imino group (-NH-), a substituted imino group (-$NR^{31}$-, where $R^{31}$ is an aliphatic group, an aromatic group, or a heterocyclic group), or a carbonyl group (-CO-).

In Formula (iii), $R^4$, $R^5$, and $R^6$ each independently represent a hydrogen atom, a halogen atom (for example, a fluorine atom, a chlorine atom, a bromine atom, or the like), an alkyl group (for example, a methyl group, an ethyl group, a propyl group, or the like) having 1 to 6 carbon atoms, Z, or L-Z. Here, L and Z have the same definitions as the groups described above. $R^4$, $R^5$, and $R^6$ are preferably a hydrogen atom or an alkyl group having 1 to 3 carbon atoms and more preferably a hydrogen atom.

The monomer represented by Formula (i) is preferably a compound in which $R^1$, $R^2$, and $R^3$ are each a hydrogen atom or a methyl group, L is a single bond, an alkylene group, or a divalent linking group having an oxyalkylene structure, X is an oxygen atom or an imino group, and Z is an aliphatic group, a heterocyclic group, or an aromatic group.

The monomer represented by Formula (ii) is preferably a compound in which $R^1$ is a hydrogen atom or a methyl group, L is an alkylene group, and Z is an aliphatic group, a heterocyclic group, or an aromatic group. In addition, the monomer represented by Formula (iii) is preferably a compound in which $R^4$, $R^5$, and $R^6$ are each a hydrogen atom or a methyl group, and Z is an aliphatic group, a heterocyclic group, or an aromatic group.

The content of the hydrophobic repeating unit in the resin A in terms of mass is preferably 10% to 90% by mass and more preferably 20% to 80% by mass with respect to the total mass of the resin A.

· Functional group capable of forming interaction with magnetic particles

The resin A may have a functional group capable of forming an interaction with magnetic particles.

The resin A preferably further contains a repeating unit containing a functional group capable of forming an interaction with magnetic particles.

Examples of the functional group capable of forming an interaction with magnetic particles include an acid group, a basic group, a coordinating group, and a functional group having reactivity.

In a case where the resin A includes an acid group, a basic group, a coordinating group, or a reactive functional group, it is preferable that the resin A includes a repeating unit including an acid group, a repeating unit including a basic group, a repeating unit including a coordinating group, or a repeating unit including a reactive functional group, respectively.

The repeating unit containing an alkali-soluble group as the acid group may be the same repeating unit as the above-mentioned repeating unit containing a graft chain, or may be a repeating unit different from the above-mentioned repeating unit containing a graft chain, but the repeating unit containing an alkali-soluble group as the acid group is a repeating unit different from the above-mentioned hydrophobic repeating unit (that is, the repeating unit containing an alkali-soluble group as the acid group does not correspond to the above-mentioned hydrophobic repeating unit).

Examples of the acid group, which is a functional group capable of forming an interaction with magnetic particles, include a carboxylic acid group, a sulfonic acid group, a phosphoric acid group, and a phenolic hydroxyl group, with at least one of a carboxylic acid group, a sulfonic acid group, or a phosphoric acid group being preferred, and a carboxylic acid group being more preferred. The carboxylic acid group has favorable adsorption power to magnetic particles and high dispersibility.

That is, it is preferable that the resin A further contains a repeating unit containing at least one of a carboxylic acid group, a sulfonic acid group, or a phosphoric acid group.

The resin A may have one or two or more repeating units containing an acid group.

In a case where the resin A contains a repeating unit containing an acid group, the content of the repeating unit containing an acid group in terms of mass is preferably 5% to 80% by mass and more preferably 10% to 60% by mass with respect to the total mass of the resin A.

Examples of the basic group, which is a functional group capable of forming an interaction with magnetic particles, include a primary amino group, a secondary amino group, a tertiary amino group, a heterocyclic ring containing

an N atom, and an amide group. From the viewpoint of favorable adsorption power to magnetic particles and high dispersibility, the preferred basic group is a tertiary amino group. The resin A may contain one or two or more of these basic groups.

In a case where the resin A contains a repeating unit containing a basic group, the content of the repeating unit containing a basic group in terms of mass is preferably 0.01% to 50% by mass and more preferably 0.01% to 30% by mass with respect to the total mass of the resin A.

Examples of the coordinating group and the functional group having reactivity, which are functional groups capable of forming an interaction with magnetic particles, include an acetylacetoxy group, a trialkoxysilyl group, an isocyanate group, an acid anhydride, and an acid chloride. From the viewpoint of favorable adsorption power to magnetic particles and high dispersibility of magnetic particles, the preferred functional group is an acetylacetoxy group. The resin A may have one or two or more of these groups.

In a case where the resin A contains a repeating unit containing a coordinating group or a repeating unit containing a functional group having reactivity, the content of the repeating unit containing a coordinating group or the repeating unit containing a functional group having reactivity in terms of mass is preferably 10% to 80% by mass and more preferably 20% to 60% by mass with respect to the total mass of the resin A.

In a case where the resin A contains a functional group capable of forming an interaction with magnetic particles in addition to the graft chain, it is sufficient that the resin A contains a functional group capable of forming an interaction with the various magnetic particles, and how the functional group is introduced is not particularly limited. For example, it is preferable that the resin to be incorporated into the composition contain one or more repeating units selected from repeating units derived from the monomers represented by the following Formulas (iv) to (vi).

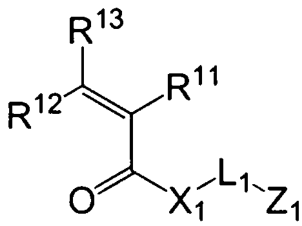

(iv)

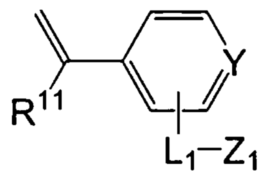

(v)

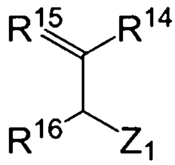

(vi)

In Formula (iv) to Formula (vi), $R^{11}$, $R^{12}$, and $R^{13}$ each independently represent a hydrogen atom, a halogen atom (for example, a fluorine atom, a chlorine atom, or a bromine atom), or an alkyl group having 1 to 6 carbon atoms (for example, a methyl group, an ethyl group, or a propyl group).

In Formulae (iv) to (vi), $R^{11}$, $R^{12}$, and $R^{13}$ are each preferably a hydrogen atom or an alkyl group having 1 to 3 carbon atoms, and more preferably a hydrogen atom or a methyl group. In the general formula (iv), hydrogen atoms are more preferable as $R^{12}$ and $R^{13}$

In Formula (iv), $X_1$ represents an oxygen atom (-O-) or an imino group (-NH-), and is preferably an oxygen atom.

In addition, in Formula (v), Y represents a methine group or a nitrogen atom.

In addition, in Formulae (iv) and (v), $L_1$ represents a single bond or a divalent linking group. The divalent linking group has the same definition as the divalent linking group represented by L in Formula (i) described above.

$L_1$ is preferably a single bond, an alkylene group, or a divalent linking group having an oxyalkylene structure. The oxyalkylene structure is more preferably an oxyethylene structure or an oxypropylene structure. In addition, $L_1$ may have a polyoxyalkylene structure which includes two or more repeating oxyalkylene structures. As the polyoxyalkylene structure, a polyoxyethylene structure or a polyoxypropylene structure is preferable. The polyoxyethylene structure is represented by $-(OCH_2CH_2)_n-$, and n is preferably an integer of 2 or more and more preferably an integer of 2 to 10.

In Formula (iv) to Formula (vi), $Z_1$ represents a functional group capable of forming an interaction with magnetic particles other than the graft chain, which is preferably a carboxylic acid group or a tertiary amino group, and more preferably a carboxylic acid group.

In Formula (vi), $R^{14}$, $R^{15}$, and $R^{16}$ each independently represent a hydrogen atom, a halogen atom (for example, a fluorine atom, a chlorine atom, a bromine atom, or the like), an alkyl group (for example, a methyl group, an ethyl group, a propyl group, or the like) having 1 to 6 carbon atoms, $-Z_1$, or $L_1$-$Z_1$. Here, $L_1$ and $Z_1$ have the same definitions as $L_1$ and $Z_1$ described above, and preferred examples thereof are also the same. $R^{14}$, $R^{15}$, and $R^{16}$ are each preferably a hydrogen atom or an alkyl group having 1 to 3 carbon atoms and more preferably a hydrogen atom.

The monomer represented by Formula (iv) is preferably a compound in which $R^{11}$, $R^{12}$, and $R^{13}$ are each independently a hydrogen atom or a methyl group, $L_1$ is an alkylene group or a divalent linking group having an oxyalkylene structure, $X_1$ is an oxygen atom or an imino group, and $Z_1$ is a carboxylic acid group.

In addition, the monomer represented by Formula (v) is preferably a compound in which $R^{11}$ is a hydrogen atom or a methyl group, $L_1$ is an alkylene group, $Z_1$ is a carboxylic acid group, and Y is a methine group.

Furthermore, the monomer represented by Formula (vi) is preferably a compound in which $R^{14}$, $R^{15}$, and $R^{16}$ are each independently a hydrogen atom or a methyl group and $Z_1$ is a carboxylic acid group.

From the viewpoint of interaction with magnetic particles, temporal stability, and permeability into a developer, the content of the repeating unit containing a functional group capable of forming an interaction with magnetic particles is preferably 0.05% to 90% by mass, more preferably 1.0% to 80% by mass, and still more preferably 10% to 70% by mass with respect to the total mass of the resin A in terms of mass.

· Ethylenically unsaturated group

The resin A may contain an ethylenically unsaturated group.

The ethylenically unsaturated group is not particularly limited, and examples thereof include a (meth)acryloyl group, a vinyl group, and a styryl group; and a (meth)acryloyl group is preferable.

Above all, the resin A preferably contains a repeating unit containing an ethylenically unsaturated group in the side chain, and more preferably a repeating unit containing an ethylenically unsaturated group in the side chain and derived from (meth)acrylate (hereinafter, also referred to as "(meth)acrylic repeating unit containing an ethylenically unsaturated group in the side chain").

The (meth)acrylic repeating unit containing an ethylenically unsaturated group in the side chain is obtained, for example, by subjecting a carboxylic acid group in the resin A containing a (meth)acrylic repeating unit containing a carboxylic acid group to an addition reaction with an ethylenically unsaturated compound containing a glycidyl group or an alicyclic epoxy group. The (meth)acrylic repeating unit including an ethylenically unsaturated group on a side chain can be obtained by reacting the ethylenically unsaturated group (glycidyl group or alicyclic epoxy group) introduced in this manner.

In a case where the resin A contains a repeating unit containing an ethylenically unsaturated group, the content of the repeating unit containing an ethylenically unsaturated group in terms of mass is preferably 30% to 70% by mass and more preferably 40% to 60% by mass with respect to the total mass of the resin A.

· Other repeating units

Further, for the purpose of improving various performances such as a film forming ability, the resin A may further have other repeating units having various functions, which are different from the repeating unit containing a graft chain, the hydrophobic repeating unit, and the repeating unit containing a functional group capable of forming an interaction with magnetic particles, as long as the effect of the present invention is not impaired.

Examples of such other repeating units include repeating units derived from radically polymerizable compounds selected from acrylonitriles, methacrylonitriles, or the like.

One or two or more of these other repeating units can be used in the resin A, and the content thereof in terms of mass is preferably 0% to 80% by mass and more preferably 10% to 60% by mass with respect to the total mass of the resin A.

· Physical properties of resin A

The acid value of the resin A is not particularly limited and is, for example, preferably 0 to 400 mgKOH/g, more preferably 10 to 350 mgKOH/g, still more preferably 30 to 300 mgKOH/g, and particularly preferably 50 to 200 mgKOH/g.

In a case where the acid value of the resin A is 50 mgKOH/g or more, the sedimentation stability of the magnetic particles can be further improved.

In the present specification, the acid value can be calculated, for example, from the average content of acid

groups in the compound. In addition, a resin having a desired acid value can be obtained by changing the content of the repeating unit including an acid group in the resin.

The weight-average molecular weight of the resin A is not particularly limited and is, for example, preferably 3,000 or more, more preferably 4,000 or more, still more preferably 5,000 or more, and particularly preferably 6,000 or more. In addition, the upper limit value of the weight-average molecular weight of the resin A is, for example, preferably 300,000 or less, more preferably 200,000 or less, still more preferably 100,000 or less, and particularly preferably 50,000 or less.

The resin A can be synthesized based on a known method.

(Alkali-soluble resin)

The resin may include an alkali-soluble resin. In the present specification, the alkali-soluble resin means a resin containing a group that promotes alkali solubility (an alkali-soluble group, for example, an acid group such as a carboxylic acid group), and means a resin different from the resin A described above.

The alkali-soluble resin may be, for example, a resin containing at least one alkali-soluble group in a molecule, examples of which include a polyhydroxystyrene resin, a polysiloxane resin, a (meth)acrylic resin, a (meth)acrylamide resin, a (meth)acryl/(meth)acrylamide copolymer, an epoxy resin, and a polyimide resin.

Specific examples of the alkali-soluble resin include a copolymer of an unsaturated carboxylic acid and an ethylenically unsaturated compound.

The unsaturated carboxylic acid is not particularly limited; however, examples thereof include monocarboxylic acids such as (meth)acrylic acid, crotonic acid, and vinylacetic acid; dicarboxylic acids such as itaconic acid, maleic acid, and fumaric acid, or an acid anhydride thereof; and polyvalent carboxylic acid monoesters such as mono(2-(meth) acryloyloxyethyl)phthalates.

The copolymerizable ethylenically unsaturated compound may be, for example, methyl (meth)acrylate. Moreover, the compounds described in paragraph 0027 of JP2010-097210A and paragraphs 0036 and 0037 of JP2015-068893A can also be used, the contents of which are incorporated into the present specification.

In addition, a copolymerizable ethylenically unsaturated compound which contains an ethylenically unsaturated group in the side chain may be used in combination. That is, the alkali-soluble resin may contain a repeating unit containing an ethylenically unsaturated group in the side chain.

The ethylenically unsaturated group contained in the side chain is preferably a (meth)acrylic acid group.

The repeating unit containing an ethylenically unsaturated group in the side chain is obtained, for example, by subjecting a carboxylic acid group of a (meth)acrylic repeating unit containing a carboxylic acid group to an addition reaction with an ethylenically unsaturated compound containing a glycidyl group or an alicyclic epoxy group.

An alkali-soluble resin containing a curable group is also preferable as the alkali-soluble resin.

Examples of the curable group include, but are not limited to, ethylenically unsaturated groups (for example, a (meth)acryloyl group, a vinyl group, and a styryl group) and cyclic ether groups (for example, an epoxy group and an oxetanyl group).

Above all, from the viewpoint that polymerization can be controlled by a radical reaction, the curable group is preferably an ethylenically unsaturated group and more preferably a (meth)acryloyl group.

An alkali-soluble resin having a curable group in the side chain or the like is preferable as the alkali-soluble resin containing a curable group. Examples of the alkali-soluble resin including a curable group include DIANAL NR series (manufactured by Mitsubishi Rayon Co., Ltd.), Photomer 6173 (COOH-containing polyurethane acrylic oligomer, manufactured by Diamond Shamrock Co., Ltd.), VISCOAT R-264 and KS resist 106 (all manufactured by OSAKA ORGANIC CHEMICAL INDUSTRY LTD.), CYCLOMER P series (for example, ACA230AA) and PLACCEL CF200 series (all manufactured by DAICEL CORPORATION), Ebecryl 3800 (manufactured by DAICEL-ALLNEX LTD.), and ACRYCURE RD-F8 (manufactured by NIPPON SHOKUBAI CO., LTD.).

A polyimide precursor can also be used as the alkali-soluble resin. The polyimide precursor refers to a resin obtained by subjecting a compound containing an acid anhydride group and a diamine compound to an addition polymerization reaction at a temperature of 40°C to 100°C.

As the alkali-soluble resin, a [benzyl(meth)acrylate / (meth)acrylic acid / another addition-polymerizable vinyl monomer as necessary] copolymer and a [allyl(meth)acrylate / (meth)acrylic acid / another addition-polymerizable vinyl monomer as necessary] copolymer are suitable since they have an excellent balance of film hardness, sensitivity, and developability.

One of the aforementioned other addition-polymerizable vinyl monomers may be used alone, or two or more of such monomers may be used in combination.

The copolymer preferably has a curable group, and more preferably contains an ethylenically unsaturated group such as a (meth)acryloyl group.

For example, monomers have a curable group may be used as the aforementioned other addition-polymerizable vinyl monomers such that the curable group is introduced into the copolymers. In addition, a curable group (preferably an

ethylenically unsaturated group such as a (meth)acryloyl group) may be introduced into some or all of one or more units derived from (meth)acrylic acid and/or one or more units derived from the aforementioned other addition-polymerizable vinyl monomers in the copolymers.

Examples of the other addition-polymerizable vinyl monomer include methyl (meth)acrylate, a styrene-based monomer (hydroxystyrene, and the like), and an ether dimer.

Examples of the ether dimer include a compound represented by General Formula (ED1) and a compound represented by General Formula (ED2).

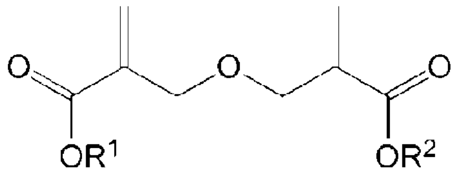

(ED1)

In General Formula (ED1), $R^1$ and $R^2$ each independently represent a hydrogen atom or a hydrocarbon group with a carbon number of 1 to 25.

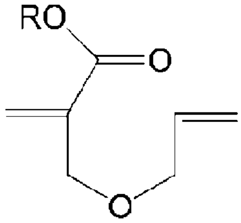

(ED2)

In General Formula (ED2), R represents a hydrogen atom or an organic group having 1 to 30 carbon atoms. For specific examples of General Formula (ED2), the description of JP2010-168539A can be referred to.

For specific examples of the ether dimer, for example, paragraph "0317" of JP2013-029760A can be referred to, and what are described in the paragraph are incorporated into the present specification. The ether dimer may be only one type or may be two or more types.

The acid value of the alkali-soluble resin is not particularly limited and is preferably 30 to 500 mgKOH/g and more preferably 50 to 200 mgKOH/g or more.

In a case where the composition contains an alkali-soluble resin, the content of the alkali-soluble resin is preferably 0.1% to 40% by mass, more preferably 0.5% to 30% by mass, and still more preferably 1% to 20% by mass with respect to the total mass of the composition.

In a case where the composition contains an alkali-soluble resin, the content of the resin A is preferably 0.1% to 40% by mass, more preferably 0.5% to 30% by mass, and even more preferably 1% to 20% by mass with respect to the solid content of the composition.

<Solvent>

The composition may contain a solvent. Examples of the solvent include water and an organic solvent, with an organic solvent being preferred.

From the viewpoint of coating properties, a boiling point of the solvent is preferably 100°C to 400°C, more preferably 150°C to 300°C, and still more preferably 170°C to 250°C. In the present specification, the boiling point means a standard boiling point unless otherwise specified.

Examples of the organic solvent include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, cyclopentanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 1,4-butanediol diacetate, 3-methoxypropyl acetate, N,N-dimethylformamide, dimethyl sulfoxide, γ-butyrolactone, ethyl acetate, butyl acetate, methyl lactate, N-methyl-2-pyrrolidone, and ethyl lactate, but the organic solvent is not limited thereto.

A content of the solvent is preferably 1% to 60% by mass, more preferably 2% to 50% by mass, and still more

preferably 3% to 40% by mass with respect to the total mass of the composition.

<Polymerization initiator>

The composition may contain a polymerization initiator.

The polymerization initiator is not particularly limited, and known polymerization initiators can be used. Examples of the polymerization initiator include a photopolymerization initiator and a thermal polymerization initiator, and a photopolymerization initiator is preferable. The polymerization initiator is preferably a so-called radical polymerization initiator.

The content of the polymerization initiator in the composition is not particularly limited and is preferably 0.5% to 15% by mass, more preferably 1.0% to 10% by mass, and still more preferably 1.5% to 8.0% by mass with respect to the total mass content of the composition.

The content of the polymerization initiator in the composition is not particularly limited and is preferably 0.5% to 15% by mass, more preferably 1.0% to 15% by mass, and still more preferably 1.5% to 12% by mass with respect to the total solid content of the composition.

Examples of the photopolymerization initiator include a halogenated hydrocarbon derivative (for example, a compound having a triazine skeleton or a compound having an oxadiazole skeleton), an acylphosphine compound, a hexaarylbiimidazole, an oxime compound, an organic peroxide, a thio compound, a ketone compound, an aromatic onium salt, an α-hydroxy ketone compound, and an α-amino ketone compound. From the viewpoint of exposure sensitivity, the photopolymerization initiator is preferably a trihalomethyltriazine compound, a benzyldimethylketal compound, an α-hydroxyketone compound, an α-aminoketone compound, an acylphosphine compound, a phosphine oxide compound, a metallocene compound, an oxime compound, a triarylimidazole dimer, an onium compound, a benzothiazole compound, a benzophenone compound, an acetophenone compound, a cyclopentadiene-benzene-iron complex, a halomethyloxadiazole compound, or a 3-aryl-substituted coumarin compound; more preferably a compound selected from an oxime compound, an α-hydroxyketone compound, an α-aminoketone compound, and an acylphosphine compound; and still more preferably an oxime compound. In addition, examples of the photopolymerization initiator include the compounds described in paragraphs 0065 to 0111 of JP2014-130173A, the compounds described in JP6301489B, the peroxide-based photopolymerization initiators described in MATERIAL STAGE, pp. 37-60, vol. 19, No. 3, 2019, the photopolymerization initiators described in WO2018/221177A, the photopolymerization initiators described in WO2018/110179A, the photopolymerization initiators described in JP2019-043864A, the photopolymerization initiators described in JP2019-044030A, the peroxide-based initiators described in JP2019-167313A, the aminoacetophenone-based initiators having an oxazolidine group described in JP2020-055992A, and the oxime-based photopolymerization initiators described in JP2013-190459A, in which the entire contents of these publications are incorporated herein by reference.

Examples of commercially available products of the α-hydroxyketone compound include OMNIRAD 184, OMNIRAD 1173, OMNIRAD 2959, and OMNIRAD 127 (all of which are manufactured by IGM Resins B.V.), and IRGACURE 184, IRGACURE 1173, IRGACURE 2959, and IRGACURE 127 (all of which are manufactured by BASF SE). Examples of commercially available products of the α-aminoketone compound include OMNIRAD 907, OMNIRAD 369, OMNIRAD 369E, and OMNIRAD 379EG (all of which are manufactured by IGM Resins B.V.), and IRGACURE 907, IRGACURE 369, IRGACURE 369E, and IRGACURE 379EG (all of which are manufactured by BASF SE). Examples of commercially available products of the acylphosphine compound include OMNIRAD 819 and OMNIRAD TPO (both of which are manufactured by IGM Resins B.V.), and IRGACURE 819 and IRGACURE TPO (both of which are manufactured by BASF SE).

Examples of the oxime compound include the compounds described in JP2001-233842A, the compounds described in JP2000-080068A, the compounds described in JP2006-342166A, the compounds described in J. C. S. Perkin II (1979, pp. 1653 to 1660), the compounds described in J. C. S. Perkin II (1979, pp. 156 to 162), the compounds described in Journal of Photopolymer Science and Technology (1995, pp. 202 to 232), the compounds described in JP2000-066385A, the compounds described in JP2004-534797A, the compounds described in JP2006-342166A, the compounds described in JP2017-019766A, the compounds described in JP6065596B, the compounds described in WO2015/152153A, the compounds described in WO2017/051680A, the compounds described in JP2017-198865A, the compounds described in paragraphs 0025 to 0038 of WO2017/164127A, and the compounds described in WO2013/167515A. Specific examples of the oxime compound include 3-benzoyloxyiminobutan-2-one, 3-acetoxyiminobutan-2-one, 3-propionyloxyiminobutan-2-one, 2-acetoxyiminopentan-3-one, 2-acetoxyimino-1-phenylpropan-1-one, 2-benzoyloxyimino-1-phenylpropan-1-one, 3-(4-toluenesulfonyloxy)iminobutan-2-one, and 2-ethoxycarbonyloxyimino-1-phenylpropan-1-one. Examples of a commercially available product thereof include Irgacure OXE01, Irgacure OXE02, Irgacure OXE03, and Irgacure OXE04 (all of which are manufactured by BASF), TR-PBG-304 (manufactured by TRONLY), and ADEKA OPTOMER N-1919 (manufactured by ADEKA Corporation; photopolymerization initiator 2 described in JP2012-014052A). In addition, as the oxime compound, it is also preferable to use a compound having no colorability or a compound having high transparency and being resistant to discoloration. Examples of commercially

available products of such compounds include ADEKA ARKLS NCI-730, NCI-831, and NCI-930 (all of which are manufactured by ADEKA Corporation).

An oxime compound having a fluorene ring can also be used as the photopolymerization initiator. Specific examples of the oxime compound having a fluorene ring include compounds described in JP2014-137466A, compounds described in JP6636081B, and compounds described in KR10-2016-0109444A.

As the photopolymerization initiator, an oxime compound having a skeleton in which at least one benzene ring of a carbazole ring is a naphthalene ring can also be used. Specific examples of such an oxime compound include the compounds described in WO2013/083505A.

An oxime compound having a fluorine atom can also be used as the photopolymerization initiator. Specific examples of the oxime compound having a fluorine atom include the compounds described in JP2010-262028A, Compounds 24, and 36 to 40 described in JP2014-500852A, and Compound (C-3) described in JP2013-164471A.

An oxime compound having a nitro group can be used as the photopolymerization initiator. The oxime compound having a nitro group is also preferably used in the form of a dimer. Specific examples of the oxime compound having a nitro group include the compounds described in paragraphs 0031 to 0047 of JP2013-114249A and paragraphs 0008 to 0012 and 0070 to 0079 of JP2014-137466A, the compounds described in paragraphs 0007 to 0025 of JP4223071B, and ADEKA ARKLS NCI-831 (manufactured by ADEKA Corporation).

An oxime compound having a benzofuran skeleton can also be used as the photopolymerization initiator. Specific examples thereof include OE-01 to OE-75 described in WO2015/036910A.

In the present invention, as the photopolymerization initiator, an oxime compound in which a substituent having a hydroxy group is bonded to a carbazole skeleton can also be used. Examples of such a photopolymerization initiator include the compounds described in WO2019/088055A.

Specific examples of the oxime compound which are preferably used in the present invention are shown below, but the present invention is not limited thereto.

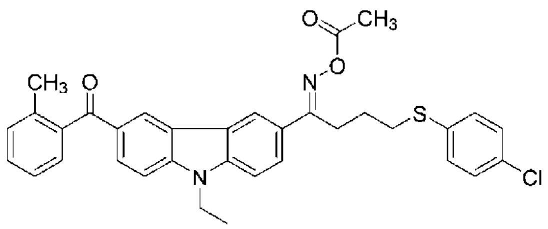

(C-1)

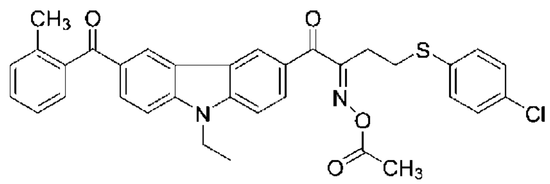

(C-2)

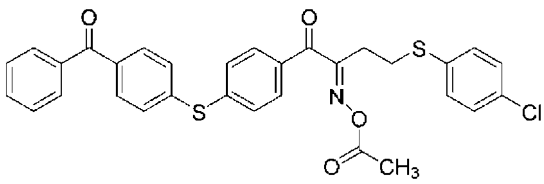

(C-3)

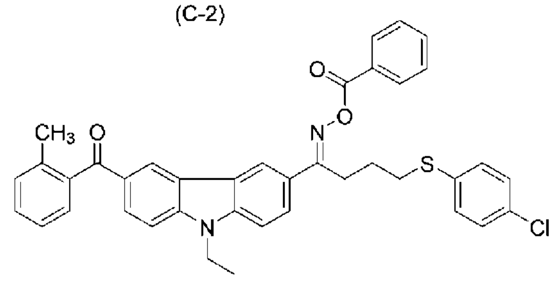

(C-4)

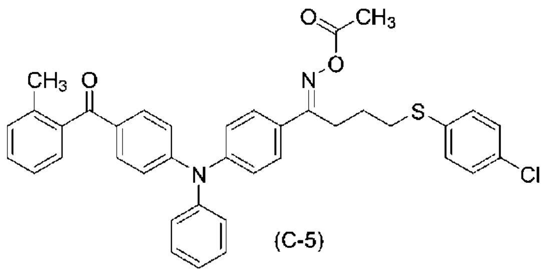

(C-5)

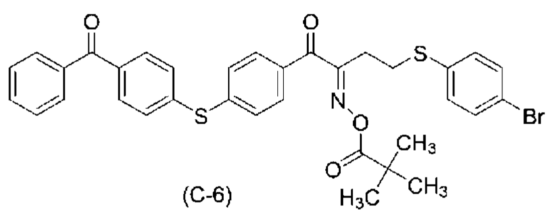

(C-6)

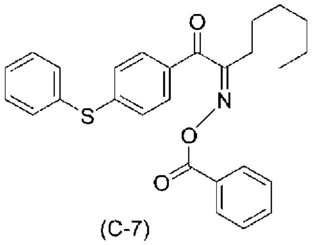

(C-7)

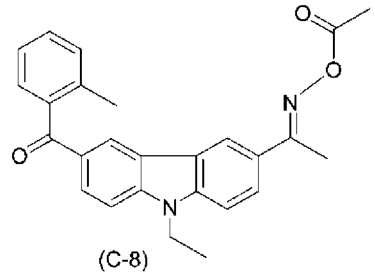

(C-8)

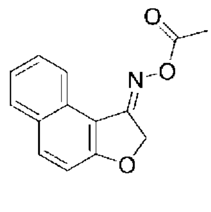

(C-9)

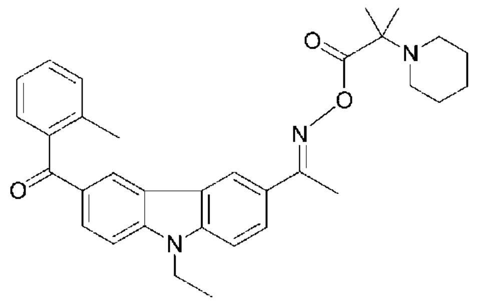

(C-10)

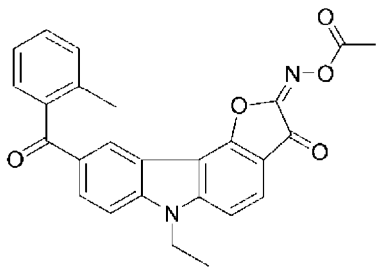

(C-11)

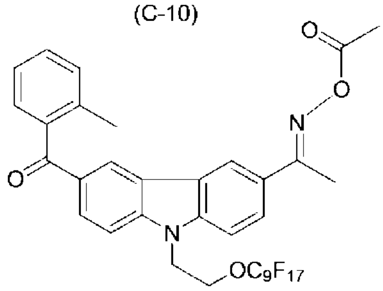

(C-12)

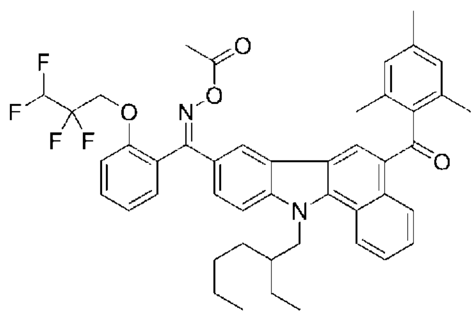

(C-13)

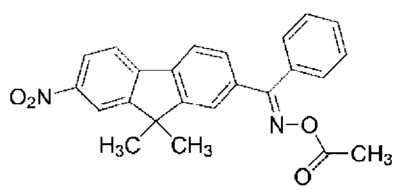

(C-14)

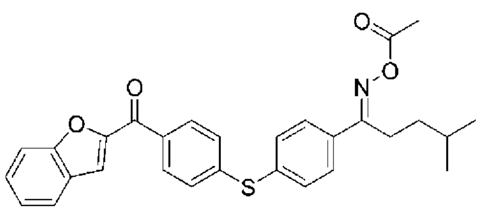

(C-15)

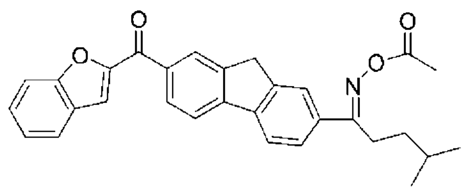

(C-16)

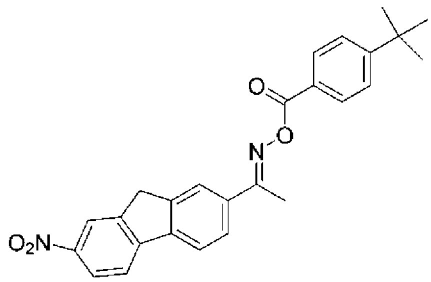

(C-17)

The oxime compound is preferably a compound having a maximal absorption wavelength in a wavelength range of 350 to 500 nm and more preferably a compound having a maximal absorption wavelength in a wavelength range of 360 to 480 nm. In addition, from the viewpoint of sensitivity, a molar absorption coefficient of the oxime compound at a wavelength of 365 nm or 405 nm is preferably high, more preferably 1000 to 300000, still more preferably 2,000 to 300,000, and particularly preferably 5,000 to 200,000. The molar absorption coefficient of a compound can be measured using a well-publicly known method. For example, the molar absorption coefficient is preferably measured by a spectrophotometer (Cary-5 spectrophotometer, manufactured by Varian) using an ethyl acetate solvent at a concentration of 0.01 g/L.

A difunctional or tri- or higher functional photoradical polymerization initiator may be used as the photopolymerization initiator. By using such a photoradical polymerization initiator, two or more radicals are generated from one molecule of the photoradical polymerization initiator, and as a result, good sensitivity is obtained. In addition, in a case where a compound having an asymmetric structure is used, the crystallinity is lowered, the solubility in a solvent or the like is improved, and the precipitation is less likely to occur over time, so that the temporal stability of the composition can be improved. Specific examples of the difunctional or trifunctional or higher functional photoradical polymerization initiator include the dimers of oxime compounds described in JP2010-527339A, JP2011-524436A, WO2015/004565A, paragraphs 0407 to 0412 of JP2016-532675A, and paragraphs 0039 to 0055 of WO2017/033680A, Compound (E) and Compound (G) described in JP2013-522445A, Compound 1 to Compound 7 described in WO2016/034963A, the oxime ester photoinitiators described in paragraph 0007 of JP2017-523465A, the photoinitiators described in paragraphs 0020 to 0033 of JP2017-167399A, Photopolymerization initiator (A) described in paragraphs 0017 to 0026 of JP2017-151342A, and the oxime ester photoinitiators described in JP6469669B.

<Other optional components>

The composition may further contain optional components other than the above-mentioned components. Examples of optional components include a surfactant, a polymerization inhibitor, an antioxidant, a sensitizer, a co-sensitizer, a crosslinking agent (a curing agent), a curing accelerator, a thermal curing accelerator, a plasticizer, a diluent, an oil sensitizing agent, and a rubber component. Further, known additives such as an agent for promoting adhesion to a substrate surface and other auxiliary agents (for example, an antifoaming agent, a flame retardant, a leveling agent, a peeling accelerator, an antioxidant, a fragrance, a surface tension adjuster, and a chain transfer agent) may be added as necessary.

(Surfactant)

Examples of the surfactant include various surfactants such as a fluorine-based surfactant, a nonionic surfactant, a cationic surfactant, an anionic surfactant, and a silicone-based surfactant. Examples of the surfactant include surfactants described in paragraphs 0238 to 0245 of WO2015/166779A, the entire contents of which are incorporated herein by reference.

Examples of the fluorine-based surfactant include the surfactants described in paragraphs 0060 to 0064 of JP2014-041318A (paragraphs 0060 to 0064 of corresponding WO2014/017669A), the entire contents of which are incorporated herein by reference, the surfactants described in paragraphs 0117 to 0132 of JP2011-132503A, the entire contents of which are incorporated herein by reference, and the surfactants described in JP2020-008634A, the entire contents of which are incorporated herein by reference. Examples of a commercially available product of the fluorine-based surfactant include: MEGAFACE F-171, F-172, F-173, F-176, F-177, F-141, F-142, F-143, F-144, F-437, F-475, F-477, F-479, F-482, F-554, F-555-A, F-556, F-557, F-558, F-559, F-560, F-561, F-563, F-565, F-568, F-575, F-780, EXP, MFS-330, R-01, R-40, R-40-LM, R-41, R-41-LM, RS-43, TF-1956, RS-90, R-94, RS-72-K, and DS-21 (all of which are manufactured by DIC Corporation); FLUORAD FC430, FC431, and FC171 (all of which are manufactured by Sumitomo 3M Ltd.); SURFLON S-382, SC-101, SC-103, SC-104, SC-105, SC-1068, SC-381, SC-383, S-393, and KH-40 (all of which are manufactured by Asahi Glass Co., Ltd.); POLYFOX PF636, PF656, PF6320, PF6520, and PF7002 (all of which

are manufactured by OMNOVA Solutions Inc.); and FTERGENT 208G, 215M, 245F, 601AD, 601ADH2, 602A, 610FM, 710FL, 710FM, 710FS, and FTX-218 (all of which are manufactured by NEOS COMPANY LIMITED).

In addition, as the fluorine-based surfactant, an acrylic compound, which has a molecular structure having a functional group containing a fluorine atom and in which, by applying heat to the molecular structure, the functional group containing a fluorine atom is broken to volatilize a fluorine atom, can also be suitably used. Examples of such a fluorine-based surfactant include MEGAFACE DS series manufactured by DIC Corporation (The Chemical Daily, February 22, 2016; Nikkei Business Daily, February 23, 2016) such as MEGAFACE DS-21.

In addition, it is also preferable to use a polymer of a fluorine atom-containing vinyl ether compound having a fluorinated alkyl group or a fluorinated alkylene ether group and a hydrophilic vinyl ether compound, as the fluorine-based surfactant. Examples of such a fluorine-based surfactant include fluorine-based surfactants described in JP2016-216602A, the contents of which are incorporated herein by reference.

A block polymer can also be used as the fluorine-based surfactant. As the fluorine-based surfactant, a fluorine-containing polymer compound including a repeating unit derived from a (meth)acrylate compound having a fluorine atom and a repeating unit derived from a (meth)acrylate compound having 2 or more (preferably 5 or more) alkyleneoxy groups (preferably ethyleneoxy groups or propyleneoxy groups) can also be preferably used. In addition, the fluorine-containing surfactants described in paragraphs 0016 to 0037 of JP2010-032698A and the following compound are also exemplified as the fluorine-based surfactants used in the present invention.

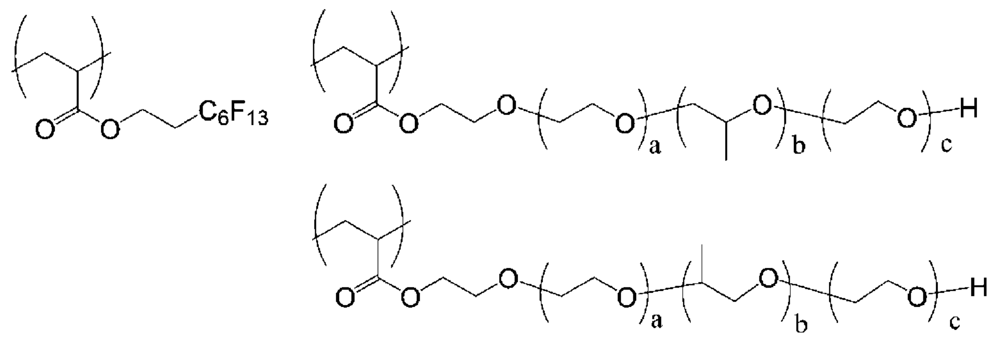

a+c=14
b=17

62% 38%

A weight-average molecular weight of the compound is preferably 3,000 to 50,000 and, for example, 14,000. In the compound, "%" representing the proportion of a repeating unit is mol%.

In addition, as the fluorine-based surfactant, a fluorine-containing polymer having an ethylenically unsaturated bond-containing group in the side chain can be used. Specific examples of such a fluorine-containing polymer include the compounds described in paragraphs 0050 to 0090 and 0289 to 0295 of JP2010-164965A, and MEGAFACE RS-101, RS-102, RS-718K, and RS-72-K (all of which are manufactured by DIC Corporation). In addition, the compounds described in paragraphs 0015 to 0158 of JP2015-117327A can also be used as the fluorine-based surfactant.

In addition, from the viewpoint of environmental regulation, it is also preferable to use the surfactant described in WO2020/084854A as a substitute for a surfactant having a perfluoroalkyl group having 6 or more carbon atoms.

In addition, it is also preferable to use a fluorine-containing imide salt compound represented by Formula (fi-1) as the surfactant.

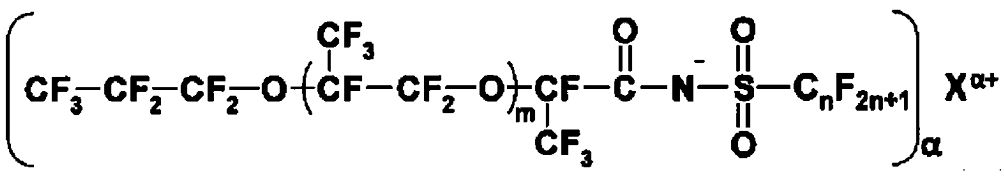

**(fi-1)**

In Formula (fi-1), m represents 1 or 2, n represents an integer of 1 to 4, $\alpha$ represents 1 or 2, and $X^{\alpha+}$ represents an $\alpha$-valent metal ion, a primary ammonium ion, a secondary ammonium ion, a tertiary ammonium ion, a quaternary ammonium ion, or $NH_4^+$.

Examples of the nonionic surfactant include glycerol, trimethylolpropane, trimethylolethane, and ethoxylates and propoxylates thereof (for example, glycerol propoxylate and glycerol ethoxylate), polyoxyethylene lauryl ether, polyoxyethylene stearyl ether, polyoxyethylene oleyl ether, polyoxyethylene octyl phenyl ether, polyoxyethylene nonyl phenyl ether, polyethylene glycol dilaurate, polyethylene glycol distearate, sorbitan fatty acid ester, PLURONIC (registered trademark) L10, L31, L61, L62, 10R5, 17R2, and 25R2 (all of which are manufactured by BASF SE), TETRONIC 304, 701, 704, 901, 904, and 150R1 (all of which are manufactured by BASF SE), SOLSPERSE 20000 (manufactured by The Lubrizol Corporation), NCW-101, NCW-1001, and NCW-1002 (all of which are manufactured by FUJIFILM Wako Pure Chemical Corporation), PIONIN D-6112, D-6112-W, and D-6315 (all of which are manufactured by Takemoto Oil & Fats Co., Ltd.), and OLFINE E1010 and SURFYNOL 104, 400, and 440 (all of which are manufactured by Nissin Chemical Co., Ltd.).

Examples of the cationic surfactant include a tetraalkylammonium salt, an alkylamine salt, a benzalkonium salt, an alkylpyridium salt, and an imidazolium salt. Specific examples thereof include dihydroxyethylstearylamine, 2-heptadecenyl-hydroxyethylimidazoline, lauryldimethylbenzylammonium chloride, cetylpyridinium chloride, and stealamidemethylpyridium chloride.

Examples of the anionic surfactant include dodecylbenzene sulfonic acid, sodium dodecylbenzene sulfonate, sodium lauryl sulfate, sodium alkyldiphenyl ether disulfonate, sodium alkylnaphthalene sulfonate, sodium dialkyl sulfosuccinate, sodium stearate, potassium oleate, sodium dioctyl sulfosuccinate, sodium polyoxyethylene alkyl ether sulfate, sodium polyoxyethylene alkylphenyl ether sulfate, sodium dialkyl sulfosuccinate, sodium stearate, sodium oleate, and sodium t-octylphenoxyethoxypolyethoxyethyl sulfate.

Examples of the silicone-based surfactant include TORAY SILICONE DC3PA, TORAY SILICONE SH7PA, TORAY SILICONE DC11PA, TORAY SILICONE SH21PA, TORAY SILICONE SH28PA, TORAY SILICONE SH29PA, TORAY SILICONE SH30PA, and TORAY SILICONE SH8400 (all of which are manufactured by Dow Corning Toray Co., Ltd.), TSF-4440, TSF-4300, TSF-4445, TSF-4460, and TSF-4452 (all of which are manufactured by Momentive Performance Materials Co., Ltd.), KP-341, KF-6001, and KF-6002 (all of which are manufactured by Shin-Etsu Chemical Co., Ltd.), BYK-307, BYK-322, BYK-323, BYK-330, BYK-3760, and BYK-UV3510 (all of which are manufactured by BYK-Chemie GmbH), and FZ-2122 (manufactured by Dow Toray Co., Ltd.).

In addition, as the silicone-based surfactant, a compound having the following structure can also be used.

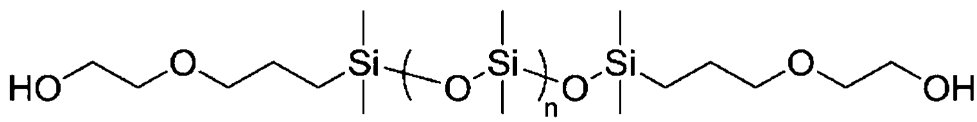

<<Composition B>>

<Magnetic particles>

Examples of the magnetic particles include the same magnetic particles as those included in the composition A, and the preferred aspects are the same.

In the composition B, the content of the magnetic particles is preferably 20% to 99% by mass, more preferably 25% to 80% by mass, and even more preferably 30% to 60% by mass based on the total mass of the composition.

The content of the magnetic particles is preferably 30% to 99% by mass, more preferably 30% to 80% by mass, and still more preferably 40% to 70% by mass with respect to the total solid content of the composition.

<Resin>

Examples of the resin include the same resin as the resin contained in the composition A, and the preferred aspect is the same.

Examples of the resin include a dispersion resin and an alkali-soluble resin.

As the alkali-soluble resin in the composition B, a phenol novolac resin, a cresol novolac resin, an alkali-soluble polyimide resin, a polybenzoxazole precursor, or the like can also be preferably used.

In the composition B, the content of the resin is preferably 0.1% to 40% by mass, more preferably 1% to 30% by mass, and even more preferably 10% to 30% by mass based on the total mass of the composition.

In the composition B, the content of the resin is preferably 0.1 to 40% by mass, more preferably 1 to 35% by mass, and even more preferably 10 to 35% by mass based on the total solid content of the composition.

In a case where the composition B contains the resin A, the content of the resin A is preferably 0.1% to 30% by mass, more preferably 0.5% to 20% by mass, and even more preferably 1% to 10% by mass based on the total mass of the composition.

In a case where the composition B contains the resin A, the content of the resin A is preferably 0.1% to 30% by mass, more preferably 0.5% to 20% by mass, and still more preferably 1% to 10% by mass based on the solid content of the composition.

In a case where the composition B contains an alkali-soluble resin, the content of the alkali-soluble resin is preferably 0.1% to 30% by mass, more preferably 1% to 30% by mass, and still more preferably 5% to 30% by mass with respect to the total mass of the composition.

In a case where the composition B contains an alkali-soluble resin, the content of the alkali-soluble resin with respect to the total solid content of the composition is preferably 0.1% to 30% by mass, more preferably 1% to 30% by mass, and even more preferably 5% to 30% by mass.

<Solvent>

Examples of the solvent include the same solvent as the solvent contained in the composition A, and the preferred aspect is the same.

A content of the solvent is preferably 1% to 60% by mass, more preferably 2% to 50% by mass, and still more preferably 3% to 40% by mass with respect to the total mass of the composition.

<Compounds that are alkali-solubilized by light irradiation>

Examples of the compound that is alkali-solubilized by light irradiation include a quinonediazide compound.

As the quinonediazide compound, a compound known as a photosensitizer of a positive resist composition can be used.

Specific examples of the quinone azide-based compound include, for example, a diazonaphthoquinone (DNQ); an ester compound of 1,2-naphthoquinone-2-diazido-5-sulfonic acid or 1,2-naphthoquinone-2-diazido-4-sulfonic acid and a low-molecular-weight aromatic hydroxyl compound (for example, 2,3,4-trihydroxybenzophenone, 1,3,5-trrihydroxybenzene, 2,3,4,4'-tetrahydroxybenzophenone, 2- and 4-methylphenol, and 4,4'-hydroxypropane); and a naphthoquinone azide derivative represented by a formula (NA), (NB), or (NC).

In Equations (NA), (NB), and (NC), at least one of R represents a substituent represented by Equation (N). In Expression (N), * represents a binding position.

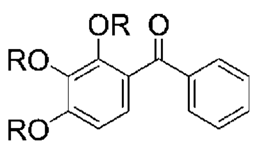

(A)

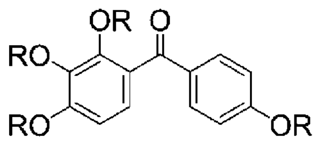

(B)

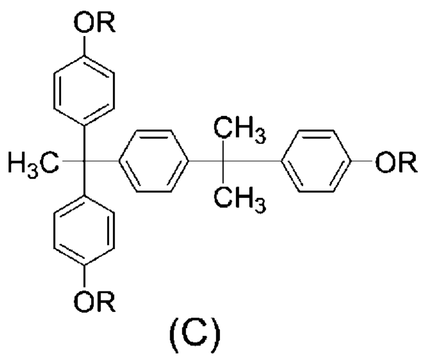

(C)

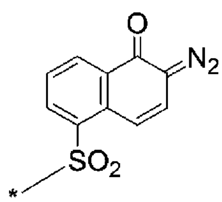

(N)

In the composition B, the content of the compound that is alkali-solubilized by light irradiation is preferably 1% to 20% by mass, more preferably 1% to 15% by mass, and still more preferably 1% to 10% by mass based on the total mass of the composition.

In the composition B, the content of the compound that is alkali-solubilized by light irradiation is preferably 1% to 20% by mass, more preferably 1% to 15% by mass, and still more preferably 1% to 10% by mass based on the total solid content of the composition.

<Crosslinking agent>

The crosslinking agent can be appropriately selected according to the type of resin.
Specific examples of the crosslinking agent include diamines, polyisocyanates, benzoxazines, and resoles, and a known compound can be appropriately used as the crosslinking agent.
In the composition B, the content of the crosslinking agent is preferably 0.1% to 20% by mass, more preferably 0.1% to 15% by mass, and even more preferably 1% to 10% by mass based on the total mass of the composition.
In the composition B, the content of the crosslinking agent is preferably 0.1 to 20% by mass, more preferably 0.1 to 15% by mass, and even more preferably 1 to 10% by mass based on the solid content of the composition.

<Other optional components>

The composition B may further contain optional components other than the above-mentioned components.
Examples of the other optional component include the same components as the other optional components contained in the composition A, and the preferred aspects are the same. Examples
Hereinafter, the present invention will be described in more detail based on Examples. The materials, the amounts of materials used, the proportions, the treatment details, the treatment procedure, and the like shown in Examples below may be appropriately modified as long as the modifications do not depart from the spirit of the present invention. Therefore, the range of the present invention will not be restrictively interpreted by the following examples.

[Pattern formation and evaluation (1)]

[Preparation of Composition Containing Magnetic Particles]

A composition (magnetic particle-containing composition) containing magnetic particles was prepared by mixing the following various components.

<Composition of magnetic particle-containing composition>

Magnetic particles (particle A below) 24.86 parts by mass Alkali-soluble resin (resin B1 below) 0.06 parts by mass Dispersant (resin B2 below) 22.38 parts by mass Polymerizable compound (KAYARAD DPHA (manufactured by Nippon Kayaku Co., Ltd., mixture of dipentaerythritol pentaacrylate and dipentaerythritol hexacrylate)) 17.08 parts by mass Polymerization initiator (compound C below) 6.98 parts by mass Surfactant (KF-6001 (manufactured by Shin-Etsu Chemical Co., Ltd., silicone surfactant)) 0.06 parts by mass Solvent (PGMEA) 28.58 parts by mass
Hereinafter, details of the components used in the preparation of the magnetic particle-containing composition are shown.

· Particle A: Particle A is barium ferrite produced by the following procedure.

<Preparation of magnetic particles>

400.0 g of water kept at a liquid temperature of 35°C was stirred, and then a raw material aqueous solution prepared by dissolving 57.0 g of iron (III) chloride hexahydrate [$FeCl_3 \cdot 6H_2O$], 25.4 g of barium chloride dihydrate [$BaCl_2 \cdot 2H_2O$], and 10.2 g of aluminum chloride hexahydrate [$AlCl_3 \cdot 6H_2O$] in 216.0 g of water, and a solution prepared by adding 113.0 g of water to 181.3 g of a sodium hydroxide aqueous solution having a concentration of 5 mol/L were added to the water being stirred at a flow rate of 10 mL/min each at the same timing of addition to obtain a first liquid.
Next, the liquid temperature of the first liquid was set to 25°C, and then 39.8 g of a sodium hydroxide aqueous solution having a concentration of 1 mol/L was added thereto in a state where the liquid temperature was kept at that temperature to obtain a second liquid. The pH of the obtained second liquid was $10.5 \pm 0.5$. The pH was measured using a desktop pH meter (F-71, manufactured by Horiba, Ltd.).
Next, the second liquid was stirred for 15 minutes to obtain a liquid containing a precipitate serving as a precursor of magnetoplumbite type hexagonal ferrite (precursor-containing liquid).
Next, the precursor-containing liquid was subjected to a centrifugation treatment (rotation speed: 2000 revolutions per minute (rpm), rotation time: 10 minutes) three times, and the resulting precipitate was recovered and washed with water.
Next, the recovered precipitate was dried in an oven at an internal atmospheric temperature of 95°C for 12 hours to obtain a powder of the precursor.
Next, the powder of the precursor was placed in a muffle furnace, and the temperature inside the furnace was set

to 1100°C in an air atmosphere and the powder was fired for 4 hours to obtain a lumpy sintered product.

Next, the obtained fired body was crushed for 90 seconds using a cutter mill (WONDER CRUSHER WC-3, manufactured by Osaka Chemical Co., Ltd.) as a crusher, setting a variable speed dial of the crusher to "5" (rotation speed: about 10,000 to 15,000 rpm) to obtain a magnetic powder.

The crystal structure of the magnetic material constituting each of the above magnetic powders was checked by X-ray diffraction analysis. As the measurement device, X'Pert Pro manufactured by PANalytical Co., Ltd., which is a powder X-ray diffractometer, was used. Measurement conditions are shown below.

-Measurement Conditions-

X-ray source: CuKα ray
[Wavelength: 1.54 Å (0.154 nm), output: 40 mA, 45 kV]
Scan range: 20° <20 < 70°
Scan interval: 0.05°
Scan speed: 0.75 °/min

As a result of the X-ray diffraction analysis, it was confirmed that the obtained magnetic powder was a powder of single-phase magnetoplumbite type hexagonal ferrite having a magnetoplumbite type crystal structure and not containing any crystal structure other than the magnetoplumbite type crystal structure.

· Resin B1: Resin having the following structure (the numerical value in each repeating unit in the following formula represents the content (mass%) with respect to the total repeating unit.)

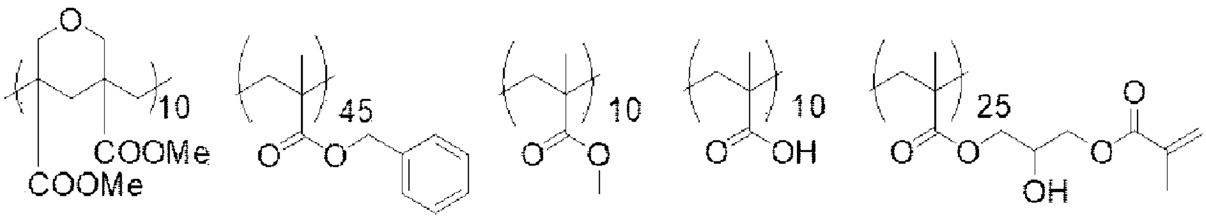

· Resin B2: Resin having the following structure (in the following formula, a to e represent the content (mol%) of each repeating unit with respect to the total repeating units. x and y represent the average addition number).

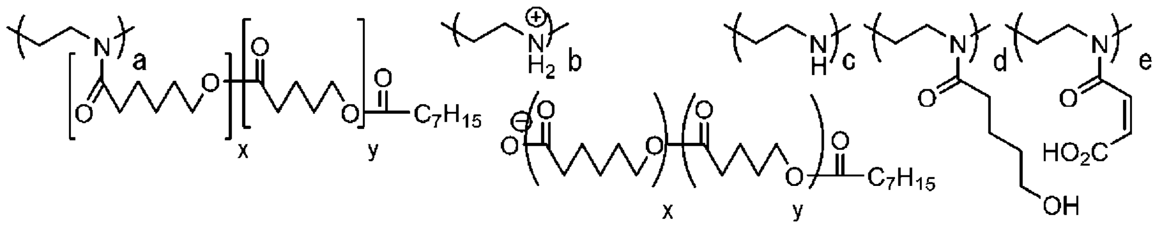

a/b/c/d/e=36/4/35/1/24 (mol%)
x=48 y=12

· Compound C: compound (oxime ester-based polymerization initiator) having the following structure

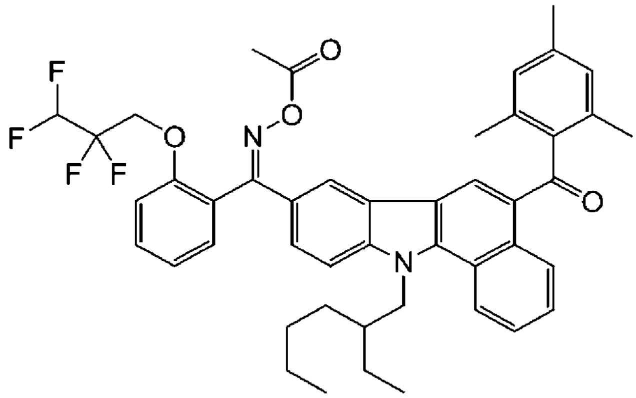

[Preparation of chemical liquid]

Each component was mixed according to the blending components and the blending amount (mass%) shown in Table 1 to prepare a chemical liquid.

Hereinafter, various components described in Table 1 will be described in detail.

<Various components of chemical liquid>

(Organic acid)

- · Acetic acid (manufactured by Wako Pure Chemical Industries, Ltd.)
- · Citric acid (manufactured by Wako Pure Chemical Industries, Ltd.)
- · Lauric acid (manufactured by Wako Pure Chemical Industries, Ltd.)

(Organic amine)

- · Diethanolamine (manufactured by Wako Pure Chemical Industries, Ltd.)
- · 2-methylaminoethanol (manufactured by Wako Pure Chemical Industries, Ltd.)
- · EPOMIN P1000 (manufactured by Nippon Kayaku Co., Ltd.)

(Organic sulfonic acid or salt thereof)

- · Sodium dodecyl sulfate (manufactured by Wako Pure Chemical Industries, Ltd.)

(Organic phosphoric acid or salt thereof)

- · Dodecyl phosphoric acid (manufactured by Tokyo Chemical Industry Co., Ltd.)

(Polyhydric alcohol)

- · Glycerin (manufactured by Wako Pure Chemical Industries, Ltd.)
- · Propylene glycol (manufactured by Wako Pure Chemical Industries, Ltd.)

(Surfactant/water-soluble polymer)

· Poloxamer 407 (manufactured by Sigma Aldrich, a compound having a polyethylene oxide structure and a polypropylene oxide structure (corresponding to a water-soluble polymer))
· MARIARIM SC0505K (manufactured by Nippon Oil Company, a compound having a polyoxyalkylene group in a side chain (corresponds to a water-soluble polymer))
· Dispanol WI-133 (manufactured by Nippon Oil and Fat Co., Ltd., a compound having a polyoxyalkylene group in a side chain (corresponding to a water-soluble polymer))
· Eslym AD3172M (manufactured by Nippon Oil Company, a compound having a polyoxyalkylene group in a side chain (corresponding to a water-soluble polymer))

(Alcohol)

· Ethanol (manufactured by Wako Pure Chemical Industries, Ltd.)

(Water)

· Ultrapure water

<Pattern formation>

A coating film was formed by applying the magnetic particle-containing composition prepared above onto a silicon wafer. Thereafter, the coating film was subjected to drying treatment at 100°C for 2 minutes.

Next, the coating film was exposed under a condition of 10 mJ/cm$^2$ by the USHIO simple exposure device via a mask having a predetermined opening.

The exposure was followed by a shower development treatment at 23°C for 60 seconds using a simple development device (manufactured by Mikasa Corporation). In addition, CD-2060 manufactured by Fujifilm Electronics Materials Co., Ltd. was used as the developing solution.

Immediately after the development, the rinsing treatment was performed by using the spray rinse nozzle to flow the chemical liquid shown in Table 1 at 23°C for 15 seconds, and then the rinsing treatment was performed by using the spray rinse nozzle to flow the ultrapure water at 23°C for 15 seconds, and finally, the spin drying treatment was performed. Thereafter, a heating treatment (post-bake) for 5 minutes was performed using a hot plate at 220°C, and a laminate in which a silicon wafer and a predetermined negative pattern were formed on the silicon wafer was obtained.

[Evaluation]

<Evaluation of defects>

A defect inspection was performed on the laminate after the above processing using a dark field defect inspection device SP1 manufactured by KLA-Tencor Corporation, and the number of defects having a size of 0.3 to 100 μm present on the laminate surface (specifically, the pattern surface and the silicon wafer surface) was measured. Defect density (pieces/cm$^2$) was calculated from the measured number of defects, and evaluation was performed according to the following evaluation criteria. The evaluation result of "C" or higher is preferable, "B" or higher is more preferable, "A" or higher is even more preferable, and "AA" is most preferable.

(Evaluation standard)

"AA": 0.015 pieces/cm$^2$ or less
"A": more than 0.015 pieces/cm$^2$, 0.03 pieces/cm$^2$ or less
"B": more than 0.03 pieces/cm$^2$ and 0.3 pieces/cm$^2$ or less

"C": more than 0.3 pieces/$cm^2$, 1.5 pieces/$cm^2$ or less
"D": more than 1.5 pieces/$cm^2$

[Table 1]

| (Table 1) Chemical liquid components (mass%) | | Example 1 | Example 2 | Example 3 | Example 4 | Example 5 | Example 6 | Example 7 | Example 8 | Example 9 | Example 10 |
|---|---|---|---|---|---|---|---|---|---|---|---|
| Organic amine and salt thereof, or organic acid and salt thereof | Acetic acid | 0.15 | | | | | | | | | |
| | Citric acid | | 0.15 | | | | 0.13 | 0.13 | 0.13 | 0.13 | 0.13 |
| | Lauric acid | | | | | | 0.02 | | | | |
| | Diethanolamine | | | 0.15 | | | | 0.02 | | | |
| | 2-methylaminoethanol | | | | 0.15 | | | | 0.02 | | |
| | Epomin P1000 | | | | | 0.15 | | | | 0.02 | |
| | Sodium dodecyl sulfate | | | | | | | | | | 0.02 |
| | Dodecyl phosphoric acid | | | | | | | | | | |
| Polyhydric alcohol | Glycerin | 2 | 2 | 2 | 2 | 2 | 2 | 2 | 2 | 2 | 2 |
| | Propylene glycol | 2 | 2 | 2 | 2 | 2 | 2 | 2 | 2 | 2 | 2 |
| Surfactant | Poloxamer-407 | 0.15 | 0.15 | 0.15 | 0.15 | 0.15 | 0.15 | 0.15 | 0.15 | 0.15 | 0.15 |
| | MALIALIM SC0505K | | | | | | | | | | |
| | DISPANOL WI-133 | | | | | | | | | | |
| | ETHREEM AD3172M | | | | | | | | | | |
| Water-soluble organic solvent | Ethanol | 22.5 | 22.5 | 22.5 | 22.5 | 22.5 | 22.5 | 22.5 | 22.5 | 22.5 | 22.5 |
| Water | Ultrapure water | 73.2 | 73.2 | 73.2 | 73.2 | 73.2 | 73.2 | 73.2 | 73.2 | 73.2 | 73.2 |
| Evaluation | Number of defects (pieces/$cm^2$) | AA | AA | AA | AA | A | AA | A | A | A | A |

[Table 2]

| (Table 1 continued) Chemical liquid components (mass%) | | Example 11 | Example 12 | Example 13 | Example 14 | Example 15 | Example 16 | Example 17 | Comparative Example 1 | Comparative Example 2 | Comparative Example 3 |
|---|---|---|---|---|---|---|---|---|---|---|---|
| Organic amine and salt thereof, or organic acid and salt thereof | Acetic acid | | 0.02 | | | | | | | | |
| | Citric acid | 0.13 | 0.13 | 0.15 | 0.15 | 0.15 | | | | | |
| | Lauric acid | | | | | | | | | | |
| | Diethanolamine | | | | | | | | | | |
| | 2-methylaminoethanol | | | | | | | | | | |
| | Epomin P1000 | | | | | | | | | | |
| | Sodium dodecyl sulfate | | | | | | | | | | |
| | Dodecyl phosphoric acid | 0.02 | | | | | | | | | |
| Polyhydric alcohol | Glycerin | 2 | 2 | 2 | 2 | 2 | 2 | | 2 | | |
| | Propylene glycol | 2 | 2 | 2 | 2 | 2 | 2 | | 2 | | |
| Surfactant | Poloxamer-407 | 0.15 | 0.15 | | | | 0.15 | 0.15 | | | |
| | MALIALIM SC0505K | | | 0.15 | | | | | | | |
| | DISPANOL WI-133 | | | | 0.15 | | | | | | |
| | ETHREEM AD3172M | | | | | 0.15 | | | | | |
| Water-soluble organic solvent | Ethanol | 22.5 | 22.5 | 22.5 | 22.5 | 22.5 | 22.5 | 22.5 | 22.5 | 22.5 | |
| Water | Ultrapure water | 73.2 | 73.2 | 73.2 | 73.2 | 73.2 | 73.35 | 77.35 | 73.5 | 77.5 | 100 |
| Evaluation | Number of defects (pieces/$cm^2$) | A | AA | AA | AA | AA | B | C | D | D | D |

From the results in Table 1, it is clear that the chemical liquid of the examples has excellent removability of the defect on the patterned substrate including the substrate and the pattern containing the magnetic particles.

In addition, it was confirmed that the chemical liquid was excellent in removability of the defect on the patterned substrate including the substrate and the pattern containing the magnetic particles in a case where the chemical liquid had a configuration including water; a surfactant containing a water-soluble polymer; a water-soluble organic solvent; a pH adjuster selected from the group consisting of an organic amine and a salt thereof and an organic acid and a salt thereof; and a polyhydric alcohol.

On the other hand, the chemical liquid of the comparative example did not exhibit the intended effect.

[Pattern formation and evaluation (2)]

[Preparation of magnetic particle-containing composition]

A magnetic particle-containing composition was prepared by mixing the following various components.

<Composition of magnetic particle-containing composition>

| | |
|---|---|
| Magnetic particles (the above particles A) | 39.23 parts by mass |
| Dispersant (resin B2) | 7.06 parts by mass |
| Alkali-soluble resin 1 (resin D below) | 13.60 parts by mass |
| photosensitive component (compound E below) | 4.77 parts by mass |
| Crosslinking agent (compound F below) | 3.68 parts by mass |
| Surfactant (KF-6001 (manufactured by Shin-Etsu ChemicalCo., Ltd., silicone-based surfactant)) | 0.04 parts by mass |
| Solvent (PGMEA) | 31.62 parts by mass |

Hereinafter, details of the components used in the preparation of the magnetic particle-containing composition are shown.

· The particles A and the resin B2 are the same as the particles A and the resin B2 used in the above-described [Pattern formation and evaluation (1)].

· Resin D: resin (novolac resin) having the following structure (in the formula, R represents a substituent selected from the group consisting of a hydrogen atom, an alkyl group, an arylene group, and an aryl group. The weight average molecular weight is about 8,000.)

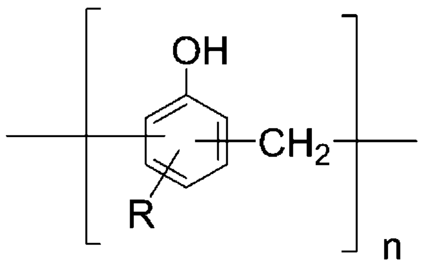

· Photosensitive component E: compound (naphthoquinone azide substituted benzophenone derivative) having the following structure (R represents a hydrogen atom or a substituent represented by the following formula (N). However, at least one of the four R's represents a substituent represented by the following Formula (N). In Formula (N), * represents a joint position).

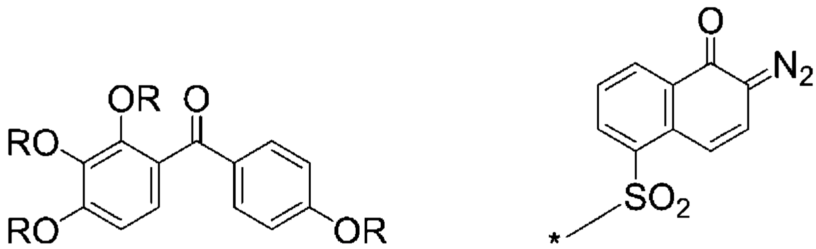

(N)

· Crosslinking agent F: compound having the following structure

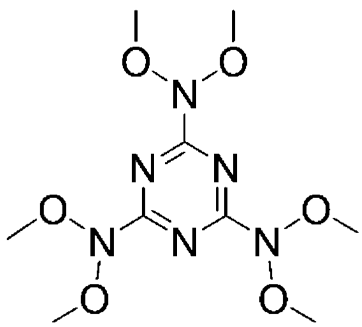

<Pattern formation>

A coating film was formed by applying the magnetic particle-containing composition prepared above onto a silicon wafer. Thereafter, the coating film was subjected to drying treatment at 100°C for 2 minutes.

Next, the coating film was exposed under a condition of 200 mJ/cm$^2$ by the USHIO simple exposure device via a mask having a predetermined opening.

Next, the coating film after the exposure treatment was subjected to a heating treatment for 2 minutes using a hot plate at 90°C.

Thereafter, the coating film was subjected to a shower development treatment at 23°C for 30 seconds using a simple development device (manufactured by Mikasa Corporation). In addition, FHD-5 manufactured by Fujifilm Electronics Materials Co., Ltd. was used as the developing solution.

Immediately after the development, the rinsing treatment was performed by using the spray rinse nozzle to flow the chemical liquid shown in Table 1 at 23°C for 15 seconds, and then the rinsing treatment was performed by using the spray rinse nozzle to flow the ultrapure water at 23°C for 15 seconds, and finally, the spin drying treatment was performed. Thereafter, a heating treatment (post-bake) for 5 minutes was performed using a hot plate at 120°C, and a laminate having a silicon wafer and a predetermined positive pattern on the silicon wafer was obtained.

The same defect evaluation as in [Pattern formation and evaluation (1)] was performed on the obtained pattern, and the same defect evaluation as in the examples and comparative examples in [Pattern formation and evaluation (1)] was obtained.

## Claims

1. A chemical liquid used in forming a pattern containing magnetic particles, the chemical liquid comprising:

   water;
   a surfactant; and
   a water-soluble organic solvent,
   wherein the surfactant includes a water-soluble polymer.

2. The chemical liquid according to claim 1,
   wherein in a case of forming the pattern containing the magnetic particles, the chemical liquid is used as a rinse liquid that is used after an alkaline development treatment.

3. The chemical liquid according to claim 1 or 2, further comprising a polyhydric alcohol.

4. The chemical liquid according to claim 1 or 2, further comprising a pH adjuster selected from the group consisting of an organic amine, a salt thereof, an organic acid, and a salt thereof.

5. The chemical liquid according to claim 1 or 2,
wherein the water-soluble organic solvent is an alcohol.

6. The chemical liquid according to claim 1 or 2,
wherein a content of the water is 60.0% by mass or more with respect to a total mass of a composition.

7. A pattern forming method comprising:

a step of applying any one of a composition A containing magnetic particles, a resin, a polymerizable compound, and a solvent, or a composition B containing magnetic particles, a resin, a compound that is alkali-solubilized by light irradiation, a crosslinking agent, and a solvent onto a substrate to form a coating film;
a step of subjecting the coating film to pattern exposure;
a step of alkali-developing the coating film subjected to the pattern exposure; and
a step of rinsing a substrate having the alkali-developed coating film with the chemical liquid according to claim 1 to form a pattern containing the magnetic particles,
wherein in a case where the composition is the composition B, a step of performing heating treatment on the substrate having the coating film rinsed with the chemical liquid is further provided.

8. A pattern forming method comprising:

a step of applying a composition A containing magnetic particles, a resin, a polymerizable compound, and a solvent onto a substrate by an inkjet method or a screen method to form a patterned coating film;
a step of performing a curing treatment on the coating film; and
a step of washing a substrate having the cured coating film with the chemical liquid according to claim 1 to form a pattern containing the magnetic particles.

9. The pattern forming method according to claim 7 or 8,
wherein the substrate is a silicon wafer.

10. The pattern forming method according to claim 7 or 8,
wherein a thickness of the coating film is 300 μm or less.

## INTERNATIONAL SEARCH REPORT

International application No.
**PCT/JP2024/008537**

**A. CLASSIFICATION OF SUBJECT MATTER**

***G03F 7/32***(2006.01)i; ***G03F 7/004***(2006.01)i; ***G03F 7/022***(2006.01)i; ***G03F 7/027***(2006.01)i
FI: G03F7/32 501; G03F7/004 501; G03F7/022; G03F7/027

According to International Patent Classification (IPC) or to both national classification and IPC

**B. FIELDS SEARCHED**

Minimum documentation searched (classification system followed by classification symbols)

G03F7/32; G03F7/004; G03F7/022; G03F7/027

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 6-273940 A (TOKYO OHKA KOGYO CO., LTD.) 30 September 1994 (1994-09-30)<br>paragraph [0017], examples 1-7, 11 | 1-2, 6-10<br>3-5 |
| X | JP 2004-078217 A (AIR PRODUCTS AND CHEMICALS, INCORPORATED) 11 March 2004 (2004-03-11)<br>paragraph [0069], example 19 | 1-10 |
| A | JP 2001-517728 A (OLIN MICROELECTRONIC CHEMICALS, INC.) 09 October 2001 (2001-10-09)<br>claims, examples | 1-10 |

☐ Further documents are listed in the continuation of Box C.  ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **01 May 2024** | **21 May 2024** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (July 2022)

**INTERNATIONAL SEARCH REPORT**
**Information on patent family members**

International application No.
**PCT/JP2024/008537**

| Patent document cited in search report | Publication date (day/month/year) | Patent family member(s) | Publication date (day/month/year) |
|---|---|---|---|
| JP 6-273940 A | 30 September 1994 | (Family: none) | |
| JP 2004-078217 A | 11 March 2004 | US 2004/0053800 A1<br>paragraph [0060], example 19<br>EP 1580607 A2 | |
| JP 2001-517728 A | 09 October 2001 | US 5977041 A<br>claims, examples<br>WO 1999/015609 A1 | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2022065006 A
- JP 2008260927 A
- JP 2015068893 A
- JP 2013029760 A
- JP 2008292970 A
- JP 5923557 B
- JP 2010097210 A
- JP 2010168539 A
- JP 2014130173 A
- JP 6301489 B
- WO 2018221177 A
- WO 2018110179 A
- JP 2019043864 A
- JP 2019044030 A
- JP 2019167313 A
- JP 2020055992 A
- JP 2013190459 A
- JP 2001233842 A
- JP 2000080068 A
- JP 2006342166 A
- JP 2000066385 A
- JP 2004534797 A
- JP 2017019766 A
- JP 6065596 B
- WO 2015152153 A
- WO 2017051680 A
- JP 2017198865 A
- WO 2017164127 A
- WO 2013167515 A
- JP 2012014052 A
- JP 2014137466 A
- JP 6636081 B
- KR 1020160109444 A
- WO 2013083505 A
- JP 2010262028 A
- JP 2014500852 A
- JP 2013164471 A
- JP 2013114249 A
- JP 4223071 B
- WO 2015036910 A
- WO 2019088055 A
- JP 2010527339 A
- JP 2011524436 A
- WO 2015004565 A
- JP 2016532675 A
- WO 2017033680 A
- JP 2013522445 A
- WO 2016034963 A
- JP 2017523465 A
- JP 2017167399 A
- JP 2017151342 A
- JP 6469669 B
- WO 2015166779 A
- JP 2014041318 A
- WO 2014017669 A
- JP 2011132503 A
- JP 2020008634 A
- JP 2016216602 A
- JP 2010032698 A
- JP 2010164965 A
- JP 2015117327 A
- WO 2020084854 A


### Non-patent literature cited in the description


- **A. J. LEO**. Comprehensive Medicinal Chemistry. Pergamon Press, 1990, vol. 4, 295
- Substituent Constants For Correlation Analysis. **C. HANSCH** ; **A. J. LEO.** Chemistry and Biology. John Wiley & Sons
- **A. J. LEO.** Calculating log Poct from structure.. *Chem. Rev.*, 1993, vol. 93, 1281-1306
- *MATERIAL STAGE*, 2019, vol. 19 (3), 37-60
- *J. C. S. Perkin*, 1979, vol. II, 1653-1660
- *J. C. S. Perkin*, 1979, vol. II, 156-162
- *Journal of Photopolymer Science and Technology*, 1995, 202-232
- *The Chemical Daily*, 22 February 2016
- *Nikkei Business Daily*, 23 February 2016